# EUROPEAN PATENT APPLICATION

(11) **EP 4 626 164 A1**
(43) Date of publication of application: **01.10.2025**
(21) Application number: 23895988.6
(22) Date of filing: 28.06.2023
(51) Int. Cl.: H10B 12/00

(54) **STORAGE ARRAY, MEMORY, AND ELECTRONIC DEVICE**

(30) Priority: 30.11.2022 CN 202211520753
(71) Applicant: Huawei Technologies Co., Ltd., Shenzhen, Guangdong 518129 (CN)
(72) Inventor: JIAO, Guangfan, Shenzhen, Guangdong 518129 (CN); JING, Weiliang, Shenzhen, Guangdong 518129 (CN); HUANG, Kailiang, Shenzhen, Guangdong 518129 (CN); WANG, Zhaogui, Shenzhen, Guangdong 518129 (CN); WANG, Zhengbo, Shenzhen, Guangdong 518129 (CN)
(74) Representative: Pfenning, Meinig & Partner mbB
(86) International application number: PCT/CN2023/103503
(87) International publication number: WO 2024/113824

(57) **Abstract**

Embodiments of this application provide a memory array, a memory, and an electronic device, and relate to the field of semiconductor memory technologies, to increase a storage density of the memory. The memory array includes a substrate and a plurality of memory layers. The plurality of memory layers are stacked in a first direction perpendicular to the substrate. The memory layer includes a plurality of memory cells, first control line structures, second control line structures, and third control line structures. The memory cell includes a floating body effect transistor. The floating body effect transistor includes a first gate, a first terminal, a second terminal, and a channel located between the first terminal and the second terminal. The channel is disposed in a second direction parallel to the substrate. The first gate is separated from the channel by a gate oxide dielectric layer. The first terminal is connected to the first control line structure. The second terminal is connected to the second control line structure. The first gate is connected to the third control line structure. **In** this way, the storage density can be increased by stacking memory layers formed by memory cells with a 1TOC structure.

## Description

This application claims priority to Chinese Patent Application No. 202211520753.6, filed with the China National Intellectual Property Administration on November 30, 2022 and entitled "MEMORY ARRAY, MEMORY, AND ELECTRONIC DEVICE", which is incorporated herein by reference in its entirety.

### TECHNICAL FIELD

This application relates to the field of semiconductor storage technologies, and in particular, to a memory array, a memory including the memory array, a memory array manufacturing method, and an electronic device including the memory.

### BACKGROUND

In a computing system, as a memory structure, a dynamic random access memory (dynamic random access memory, DRAM) may be used to temporarily store computing data of a central processing unit (central processing unit, CPU) and exchange data with an external memory such as a hard disk, and is a very important part of the computing system. A floating body (floating body cell, FBC) DRAM is a DRAM formed by using a floating body effect transistor as a basic memory cell. The floating body effect transistor includes a first terminal and a second terminal that are formed on a substrate, and a channel and a gate that are located between the first terminal and the second terminal. An oxide layer is provided between top silicon and a bottom substrate. The oxide layer separates the floating body effect transistor from the bottom substrate. The floating body effect transistor forms a capacitor relative to the insulation substrate, charges may be accumulated on the capacitor, and the floating body effect transistor may be configured to store 0 or 1. Therefore, a single floating body effect transistor may be used as a memory cell.

The memory cell of the floating body DRAM includes the single floating body effect transistor, and has a simple structure. However, because a single memory cell occupies a large area, it is difficult to form a high-density memory array, affecting a storage capacity of the memory.

### SUMMARY

This application provides a memory array, a memory including the memory array, a memory array manufacturing method, and an electronic device including the memory. An objective is to provide the memory array that can increase a storage density and simplify a manufacturing process.

To achieve the foregoing objective, the following technical solutions are used in embodiments of this application.

According to a first aspect, an embodiment of this application provides a memory array. For example, the memory array may be used for a DRAM, and the memory array includes: a substrate and a plurality of memory layers formed on the substrate, where the plurality of memory layers are stacked in a first direction perpendicular to the substrate, the memory layer includes a plurality of memory cells and first control line structures, the memory cell includes a floating body effect transistor, the floating body effect transistor is also referred to as a floating body cell, and a single floating body effect transistor may form a memory cell with a 1T0C structure. The floating body effect transistor includes a first gate, a first terminal, a second terminal, and a channel located between the first terminal and the second terminal. The channel is disposed in a second direction parallel to the substrate. The first gate is separated from the channel by a gate oxide dielectric layer. The memory array further includes a plurality of second control line structures and third control line structures. The first terminal is connected to the first control line structure, the second terminal is connected to the second control line structure, and the first gate is connected to the third control line structure.

The memory array provided in this embodiment of this application includes the plurality of stacked memory layers, and a storage density can be increased by stacking the memory layers. Each memory layer includes a plurality of memory cells, and the memory cell includes the floating body effect transistor, to form the memory cell with the 1T0C structure, thereby simplifying a structure of the memory cell.

When the memory array provided in this embodiment of this application is manufactured, a plurality of dielectric layers and a plurality of semiconductor layers may be alternately stacked first, and then processing is performed on these stacked layer structures, so that a plurality of memory layers may be obtained through processing at the same time, and then the first control line structure, the second control line structure, and the third control line structure are formed. A multi-layer device in this application may be processed at the same time, that is, a multi-layer device is formed at a time, and there is no need to first manufacture a 1^{st} layer of memory array and then manufacture a 2^{nd} layer of memory array, a 3^{rd} layer of memory array, and the like layer by layer by using the same process. In this way, on one hand, the memory cell of the memory array provided in this embodiment of this application have the 1T0C structure, and a manufacturing process is simple compared with that of a memory cell with a 1T1C or 2T1C structure or the like. On the other hand, from a process perspective, for the memory array provided in this embodiment of this application, the plurality of stacked memory layers can be manufactured at a time, so that a process flow can be simplified, and the memory array does not need to be manufactured layer by layer, to reduce manufacturing costs, and further increase the storage density of the memory array.

In a possible implementation, the second control line structure includes a vertical control line extending in the first direction perpendicular to the substrate, and the vertical control line of the second control line structure is connected to the second terminal of the floating body effect transistor distributed in the first direction.

In a possible implementation, the second control line structure includes a horizontal control line extending in the second direction parallel to the substrate, and the horizontal control line of the second control line structure is connected to the vertical control line of the second control line structure distributed in the second direction.

The vertical control line of the second control line extends in the first direction perpendicular to the substrate, and is connected to the second terminal of the floating body effect transistor distributed in the first direction. As a result, a quantity of vertical control lines of the second control line structure is large. Therefore, in this embodiment of this application, the second control line structure includes the horizontal control line extending in the second direction parallel to the substrate, the horizontal control line of the second control line structure is connected to the vertical control line structure of the second control line structure distributed in the second direction, a plurality of vertical control lines of the second control line structure may be connected together and routed out, and a signal may be applied to the plurality of vertical control lines of the second control line structure by using the horizontal control line of the second control line structure, so that a quantity of leads can be reduced, a size of the memory array can be reduced, and the storage density can be increased.

In a possible implementation, the memory layer includes a first memory cell and a second memory cell, the first memory cell and the second memory cell are distributed in the second direction, and a second terminal of a floating body effect transistor of the first memory cell is close to a second terminal of a floating body effect transistor of the second memory cell. For example, the second terminal of the floating body effect transistor of the first memory cell faces the second memory cell, and the second terminal of the floating body effect transistor of the second memory cell faces the first memory cell, and the second terminal of the floating body effect transistor of the first memory cell and the second terminal of the floating body effect transistor of the second memory cell are connected to a same second control line structure.

In the memory layer provided in this embodiment of this application, every two memory cells may form a group. For example, the first memory cell and the second memory cell form a group. The second terminal of the floating body effect transistor of the first memory cell and the second terminal of the floating body effect transistor of the second memory cell are close, and may be connected to the same second control line structure. Alternatively, it may be considered that the second terminal of the floating body effect transistor of the first memory cell and the second terminal of the floating body effect transistor of the second memory cell may be integrated. In other words, a quantity of second control line structures may be halved, to reduce a size of the memory array.

In a possible implementation, the third control line structure extends in a third direction, and the third control line structure is connected to the first gate of the floating body effect transistor distributed in the third direction.

In a possible implementation, the third control line structure includes a vertical control line extending in the first direction, and the vertical control line of the third control line structure is connected to the first gate of the floating body effect transistor distributed in the first direction.

In a possible implementation, the third control line structure includes a horizontal control line extending in a third direction, and the horizontal control line of the third control line structure is connected to the vertical control line of the third control line structure distributed in the third direction.

In a possible implementation, the third control line structure includes a horizontal control line extending in the second direction, and the horizontal control line of the third control line structure is connected to the vertical control line of the third control line structure distributed in the second direction.

In this embodiment of this application, the third control line structure may extend in the third direction, and is connected to the first gate of the floating body effect transistor distributed in the third direction. Alternatively, the third control line structure may include the vertical control line extending in the first direction and the horizontal control line extending in the direction parallel to the substrate. For example, the horizontal control line may extend in the second direction or the first direction, the horizontal control line is connected to a plurality of vertical control lines, and a signal may be applied to the plurality of vertical control lines of the third control line structure by using the horizontal control line of the third control line structure. In this way, a quantity of leads can be reduced, and the size of the memory array can be reduced.

In a possible implementation, the first gate is disposed around the channel. In this way, an orthogonal projection area of the first gate of the floating body effect transistor and the channel can be increased, and a capability of the first gate to control the channel can be enhanced.

In a possible implementation, the first gate includes a first electrode and a second electrode that are paired, the first electrode and the second electrode are distributed in the third direction parallel to the substrate, the third direction is perpendicular to the second direction, and the channel is located between the first electrode and the second electrode. The first gate is disposed as a dual-electrode structure of the first electrode and the second electrode, so that the orthogonal projection area of the first gate and the channel can be increased, and a control capability of the first gate on the channel can be enhanced.

In a possible implementation, the third control line structure includes the vertical control line extending in the first direction, and the vertical control line of the third control line structure is connected to the first gate of the floating body effect transistor distributed in the first direction. Because the first gate of the floating body effect transistor includes the first electrode and the second electrode that are disposed opposite to each other, and the third control line structure is connected to the gate of the floating body effect transistor distributed in the first direction, the vertical control line of the third control line structure also includes a first electrode line and a second electrode line that are opposite to each other, the first electrode line is connected to the first electrode of the gate of the floating body effect transistor distributed in the first direction, and the second electrode line is connected to the second electrode of the gate of the floating body effect transistor distributed in the first direction.

In a possible implementation, the first control line structure extends in the third direction parallel to the substrate, and the first control line structure is connected to the first terminal of the floating body effect transistor distributed in the third direction.

In a possible implementation, the floating body effect transistor further includes a second gate, the first gate, the second gate, and the channel are separated by a gate oxide dielectric layer, the first gate and the second gate are distributed in the second direction, the first gate is close to the second terminal, the second gate is close to the first terminal, and the first gate and the second gate are separated by an insulation medium. The memory array further includes a fourth control line structure, and the second gate of the floating body effect transistor is connected to the fourth control line structure.

The memory array provided in this embodiment of this application includes the plurality of stacked memory layers, and the storage density can be increased by stacking the memory layers. Each memory layer includes the plurality of memory cells, and the memory cell includes the floating body effect transistor, to form the memory cell with the 1T0C structure, thereby simplifying the structure of the memory cell. In addition, each floating body effect transistor includes a first gate and a second gate. The first gate and the second gate are distributed in the second direction, and the first gate and the second gate are separated by an insulation medium. In this way, after data is written into the floating body effect transistor of the memory cell, charges may be stored in a corresponding channel region between the first gate and the second gate, instead of being located near the first terminal or the second terminal, and the storage location of the charges is farther from the first terminal or the second terminal. In this way, it is difficult for the stored charges to flow out of the first terminal or the second terminal, and retention time of the data can be increased.

In a possible implementation, the first gate includes the first electrode and the second electrode that are disposed opposite to each other, the first electrode of the first gate and the second electrode of the first gate are distributed in the third direction parallel to the substrate, the third direction is perpendicular to the second direction, and the channel is located between the first electrode and the second electrode of the first gate. The second gate includes a first electrode and a second electrode that are disposed opposite to each other, the first electrode of the second gate and the second electrode of the second gate are distributed in the third direction parallel to the substrate, the third direction is perpendicular to the second direction, the channel is located between the first electrode and the second electrode of the second gate, the second gate and the first gate are paired, and a structure of the second gate is basically the same as a structure of the first gate.

In a possible implementation, the third control line structure extends in the third direction, the third control line structure is connected to the first gate of the floating body effect transistor distributed in the third direction, the fourth control line structure extends in the third direction, and the fourth control line structure is connected to the second gate of the floating body effect transistor distributed in the third direction.

In a possible implementation, the third control line structure includes the vertical control line extending in the first direction, the vertical control line of the third control line structure is connected to the first gate of the floating body effect transistor distributed in the first direction, the fourth control line structure includes the vertical control line extending in the first direction, and the vertical control line of the fourth control line structure is connected to the second gate of the floating body effect transistor distributed in the first direction.

In a possible implementation, the third control line structure includes the horizontal control line extending in the third direction, the horizontal control line of the third control line structure is connected to the vertical control line of the third control line structure distributed in the third direction, the fourth control line structure includes the horizontal control line extending in the third direction, and the horizontal control line of the fourth control line structure is connected to the vertical control line of the fourth control line structure distributed in the third direction.

In a possible implementation, the third control line structure includes the horizontal control line extending in the second direction, the horizontal control line of the third control line structure is connected to the vertical control line of the third control line structure distributed in the second direction, the fourth control line structure includes the horizontal control line extending in the second direction, and the horizontal control line of the fourth control line structure is connected to the vertical control line of the fourth control line distributed in the second direction.

In this embodiment of this application, the third control line structure and the fourth control line structure may extend in the third direction, and are respectively connected to the first gate and the second gate of the floating body effect transistor distributed in the third direction. Alternatively, the third control line structure and the fourth control line structure may include the vertical control line extending in the first direction and the horizontal control line extending in the direction parallel to the substrate. For example, the horizontal control line may extend in the second direction or the first direction, the horizontal control line is connected to the plurality of vertical control lines, the signal may be applied to the plurality of vertical control lines of the third control line structure by using the horizontal control line of the third control line structure, and the signal may be applied to the plurality of vertical control lines of the fourth control line structure by using the horizontal control line of the fourth control line structure. In this way, the quantity of leads can be reduced, and the size of the memory array can be reduced.

In a possible implementation, the first gate is disposed around the channel, and the second gate is disposed around the channel. In this way, orthogonal projection areas of the first gate, the second gate, and the channel can be increased, and control capabilities of the first gate and the second gate on the channel can be enhanced.

In a possible implementation, the first gate includes the first electrode and the second electrode that are disposed opposite to each other, the first electrode and the second electrode of the first gate are distributed in the third direction parallel to the substrate, the third direction is perpendicular to the second direction, and the channel is located between the first electrode and the second electrode of the first gate. The second gate includes the first electrode and the second electrode that are disposed opposite to each other, the first electrode and the second electrode of the second gate are distributed in the third direction parallel to the substrate, the third direction is perpendicular to the second direction, and the channel is located between the first electrode and the second electrode of the second gate. The first gate is disposed as the dual-electrode structure of the first electrode and the second electrode, and the second gate is disposed as the dual-electrode structure of the first electrode and the second electrode. In this way, the orthogonal projection areas of the first gate, the second gate, and the channel can be increased, and the control capabilities of the first gate and the second gate on the channel can be enhanced.

In a possible implementation, the vertical control line of the third control line structure includes the first electrode line and the second electrode line that are opposite to each other, the first electrode line of the third control line structure is connected to the first electrode of the first gate of the floating body effect transistor distributed in the first direction, and the second electrode line of the third control line structure is connected to the second electrode of the first gate of the floating body effect transistor distributed in the first direction. The vertical control line of the fourth control line structure includes a first electrode line and a second electrode line that are opposite to each other, the first electrode line of the fourth control line structure is connected to the first electrode of the second gate of the floating body effect transistor distributed in the first direction, and the second electrode line of the fourth control line structure is connected to the second electrode of the second gate of the floating body effect transistor distributed in the first direction.

In a possible implementation, the first control line structure forms a source line, the second control line structure forms a bit line, the third control line structure forms a word line, and the fourth control line structure forms a plate line. Data may be written into the memory cell or data stored in the memory cell may be read via the source line, the bit line, the word line, and the plate line.

According to a third aspect, an embodiment of this application further provides a memory. The memory includes a controller and the memory array in any one of the foregoing implementations, the controller is electrically connected to the memory array, and the controller is configured to control reading and writing of the memory array.

The memory provided in this application includes the memory array in the foregoing implementations. The memory array includes a plurality of stacked memory layers. The memory layers include a plurality of memory cells. The memory cells include a floating body effect transistor formed based on a floating body effect, which is also referred to as a floating body cell. A memory cell with a 1T0C structure may be formed by using one floating body effect transistor. This simplifies a structure of the memory cell, and reduces difficulty of a manufacturing process. In addition, the plurality of memory layers can be stacked to implement high-density integration and increase a storage capacity.

In a possible implementation, the memory array and the controller are integrated into a same chip, and the chip is disposed on a substrate.

In a possible implementation, the memory array is integrated into a first chip, the controller is integrated into a second chip, and each of the first chip and the second chip is disposed on a substrate via an electrical connection structure.

In a possible implementation, the memory array is integrated into a first chip, the controller is integrated into a second chip, and the first chip and the second chip are stacked and integrated on a substrate.

According to a fourth aspect, an embodiment of this application further provides a memory array manufacturing method. The method includes:
forming a plurality of dielectric layers and a plurality of semiconductor layers on a substrate, and alternately stacking the plurality of dielectric layers and the plurality of semiconductor layers in a first direction perpendicular to the substrate; and
forming a plurality of memory cells, first control line structures, second control line structures, and third control line structures, where the memory cell includes a floating body effect transistor, the floating body effect transistor includes a first gate, a first terminal, a second terminal, and a channel located between the first terminal and the second terminal, the channel is disposed in a second direction parallel to the substrate, the first gate is separated from the channel by a gate oxide dielectric layer, the first terminal is connected to the first control line structure, the second terminal is connected to the second control line structure, and the first gate is connected to the third control line structure.

In the memory array manufacturing method provided in this application, the plurality of semiconductor layers and dielectric layers that are alternately disposed are first stacked, and then a plurality of memory cells, first control line structures, second control line structures, and third control line structures are formed at each semiconductor layer through processing. In this way, a plurality of memory layers can be manufactured at the same time, instead of forming one memory layer and then forming another memory layer. In addition, the memory cell provided in this embodiment of this application is formed by a single floating body effect transistor. In this way, a storage density can be increased, a manufacturing process can also be simplified.

In a possible implementation, forming the plurality of memory cells, first control line structures, second control line structures, and third control line structures includes: forming the first gate of the floating body effect transistor, where the first gate includes a first electrode and a second electrode that are opposite to each other, the first electrode and the second electrode are distributed in a third direction parallel to the substrate, the third direction is perpendicular to the second direction, and the channel is located between the first electrode and the second electrode; and forming a vertical control line of the third control line structure, where the vertical control line of the third control line includes a first electrode line and a second electrode line that are opposite to each other, the first electrode line is connected to the first electrode of the first gate of the floating body effect transistor distributed in the first direction, and the second electrode line is connected to the second electrode of the first gate of the floating body effect transistor distributed in the first direction.

In a possible implementation, forming the plurality of memory cells, first control line structures, second control line structures, and third control line structures further include: forming a second gate of the floating body effect transistor, where the second gate and the first gate are distributed in the second direction, the second gate is close to the first terminal, the first gate is close to the second terminal, the second gate includes a first electrode and a second electrode that are paired, the first electrode and the second electrode are distributed in the third direction parallel to the substrate, the third direction is perpendicular to the second direction, and the channel is located between the first electrode and the second electrode; and forming a vertical control line of a fourth control line structure, where the vertical control line of the fourth control line structure includes a first electrode line and a second electrode line that are paired, the first electrode line is connected to the first electrode of the first gate of the floating body effect transistor distributed in the first direction, and the second electrode line is connected to the second electrode of the first gate of the floating body effect transistor distributed in the first direction.

In a possible implementation, forming the plurality of memory cells, first control line structures, second control line structures, and third control line structures includes: forming a second terminal of a floating body effect transistor of a first memory cell and a second terminal of a floating body effect transistor of a second memory cell, where the second terminal of the floating body effect transistor of the first memory cell faces the second memory cell, the second terminal of the floating body effect transistor of the second memory cell faces the first memory cell, and the second terminal of the floating body effect transistor of the first memory cell and the second terminal of the floating body effect transistor of the second memory cell are connected to a same second control line structure.

In a possible implementation, forming the plurality of memory cells, first control line structures, second control line structures, and third control line structures includes: forming a vertical control line of the second control line structure, where the vertical control line of the second control line structure extends in the first direction, and the vertical control line of the second control line structure is connected to the second terminal of the floating body effect transistor distributed in the first direction.

In a possible implementation, forming the plurality of memory cells, first control line structures, second control line structures, and third control line structures includes: forming the first terminal of the floating body effect transistor; and forming the first control line structure, where the first control line structure extends in the third direction, and the first control line structure is connected to the first terminal of the floating body effect transistor distributed in the third direction.

According to a fifth aspect, an embodiment of this application further provides an electronic device, including a processor and the memory in any one of the foregoing implementations. The processor is electrically connected to the memory, and the memory is configured to store data generated by the processor.

The electronic device provided in this embodiment of this application includes the memory in any one of the foregoing implementations. Therefore, the electronic device provided in this embodiment of this application and the memory in the foregoing technical solutions can resolve a same technical problem, and achieve a same expected effect.

### BRIEF DESCRIPTION OF DRAWINGS

FIG. 1 is a diagram of an electronic device according to an embodiment of this application;
FIG. 2 is a diagram of a memory according to an embodiment of this application;
FIG. 3 is a schematic of a simple circuit of a memory according to an embodiment of this application;
FIG. 4 is a diagram of a memory cell according to an embodiment of this application;
FIG. 5 is a diagram of a structure of a floating body cell according to an embodiment of this application;
FIG. 6 is a diagram of another memory cell according to an embodiment of this application;
FIG. 7 is a diagram of writing data into a floating body cell according to an embodiment of this application;
FIG. 8 is a diagram of writing data into a floating body cell according to an embodiment of this application;
FIG. 9 is a diagram of a current for reading data from a floating body cell according to an embodiment of this application;
FIG. 10 is a diagram of a structure of another floating body cell according to an embodiment of this application;
FIG. 11 is a diagram of a memory array according to an embodiment of this application;
FIG. 12 is a schematic of a circuit of a memory layer according to an embodiment of this application;
FIG. 13 is a diagram of a structure of a memory array according to an embodiment of this application;
FIG. 14 is a cutaway view of the memory array provided in FIG. 13 in an A-A' direction;
FIG. 15 is another diagram of a memory array according to an embodiment of this application;
FIG. 16 is a diagram of a structure of a memory array according to another embodiment of this application;
FIG. 17 is a diagram of a structure of a memory array according to an embodiment of this application;
FIG. 18 is a diagram of a structure of a memory array according to another embodiment of this application;
FIG. 19 is a diagram of a structure of a memory array according to an embodiment of this application;
FIG. 20 is a diagram of a structure of a memory array according to another embodiment of this application;
FIG. 21 is a diagram of a structure of a memory array according to an embodiment of this application;
FIG. 22 is a diagram of a structure of another memory array according to an embodiment of this application;
FIG. 23 is a cutaway view of the memory array provided in FIG. 22;
FIG. 24 is a diagram of a structure of another memory array according to an embodiment of this application;
FIG. 25 is a diagram of a structure of a floating body cell according to another embodiment of this application;
FIG. 26 is a diagram of writing data into a floating body cell according to another embodiment of this application;
FIG. 27 is a diagram of writing data into a floating body cell according to another embodiment of this application;
FIG. 28 is a diagram of reading data from a floating body cell according to another embodiment of this application;
FIG. 29 is a diagram of reading data from a floating body cell according to another embodiment of this application;
FIG. 30 is a diagram of a current for reading data from a floating body cell according to another embodiment of this application;
FIG. 31 is a diagram of a structure of a memory array according to another embodiment of this application;
FIG. 32 is a cutaway view of the memory array provided in FIG. 31;
FIG. 33 is a diagram of a structure of a memory array according to another embodiment of this application;
FIG. 34 is a diagram of a structure of a memory array according to another embodiment of this application;
FIG. 35 is a cutaway view of the memory array provided in FIG. 34;
FIG. 36 is a diagram of a structure of a memory array according to another embodiment of this application;
FIG. 37 is a schematic flowchart of a memory array manufacturing method according to an embodiment of this application; and
FIG. 38 to FIG. 52 are diagrams of corresponding process structures after steps in a method are performed according to embodiments of this application.

### DESCRIPTION OF EMBODIMENTS

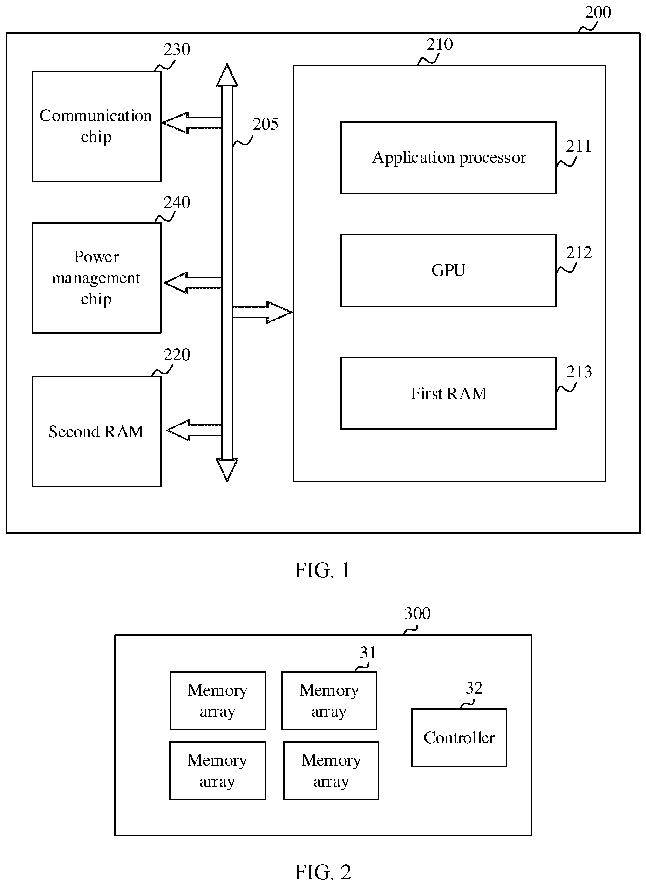

An embodiment of this application provides an electronic device. FIG. 1 is a diagram of an electronic device 200 according to an embodiment of this application. The electronic device 200 may be a terminal device, for example, a mobile phone, a tablet computer, or a smart band, or may be a personal computer (personal computer, PC), a server, a workstation, or the like.

As shown in FIG. 1, the electronic device 200 may include a bus 205 and a system on chip (system on chip, SoC) 210 connected to the bus 205. The SoC 210 may be configured to process data, for example, process data of an application, process image data, and cache temporary data. In an implementation, the SoC 210 may include an application processor (application processor, AP) 211 configured to process an application, a graphics processing unit (graphics processing unit, GPU) 212 configured to process image data, and a first random access memory (random access memory, RAM) 213 configured to cache high-speed data. The first RAM 213 may be a static random access memory (static random access memory, SRAM), an embedded flash memory (embedded flash, eflash), or the like. The AP 211, the GPU 212, and the first RAM 213 may be integrated into one die (die), or may be disposed in a plurality of dies.

As shown in FIG. 1, the electronic device 200 may further include a second RAM 220 connected to the SoC 210 via the bus 205. The second RAM 220 may be a dynamic random access memory (dynamic random access memory, DRAM). The second RAM 220 may be configured to store volatile data, for example, temporary data generated by the SoC 210. A storage capacity of the second RAM 220 is usually greater than that of the first RAM 213, but a reading speed of the second RAM 220 is usually slower than that of the first RAM 213.

In addition, the electronic device 200 may further include a communication chip 230 and a power management chip 240 that are connected to the SoC 210 via the bus 205. The communication chip 230 may be configured to process a protocol stack, or perform processing such as amplification and filtering on an analog radio frequency signal, or implement the foregoing functions at the same time. The power management chip 240 may be configured to supply power to another chip. In an implementation, the SoC 210 and the second RAM 220 may be packaged in a packaging structure, for example, 2.5D (dimension) or 3D packaging is used, to obtain a faster inter-chip data transmission rate.

FIG. 2 is a block diagram of a circuit of a memory 300 applicable to an electronic device according to an embodiment of this application. In an implementation, the memory 300 may be the first RAM 213 or the second RAM 220 shown in FIG. 1. An application scenario of the memory 300 in this application is not limited. In a possible implementation, the memory 300 may alternatively be a RAM disposed outside a SoC 210. A location of the memory 300 in the electronic device and a location relationship between the memory 300 and the SoC 210 are not limited in this application.

As shown in FIG. 2, the memory 300 includes a memory array 31 and a controller 32 configured to access the memory array 31. The controller 32 is configured to control a reading/writing operation on the memory array 31.

The memory array and the controller have a plurality of packaging structures that can be implemented. For example, the memory array and the controller are two chips that are independent of each other, and the memory array and the controller are separately integrated on a substrate. For example, the memory array and the controller may be electrically connected via a metal wire disposed on the substrate. In this structure, because the memory array and the controller are two independent chips, the memory array may be referred to as a stand-alone (stand-alone) memory.

Alternatively, the memory array and the controller are stacked. For example, the memory array and the controller may be connected through a through silicon via (through silicon via, TSV) or a redistribution layer (redistribution layer, RDL).

Alternatively, the memory array and the controller are integrated into a same chip, and the chip is integrated on a substrate. Therefore, the memory array may be referred to as an embedded memory.

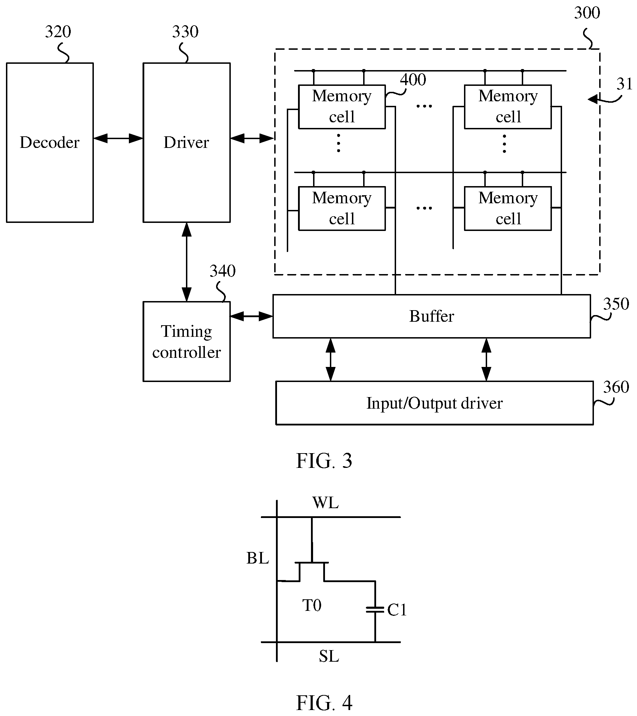

In an implementation, the memory array 31 in the memory may include a plurality of memory cells (memory cell, MC) arranged in array shown in FIG. 3, and each memory cell 400 may be configured to store 1-bit (bit) data or multi-bit data. The memory array 31 may further include control lines such as a word line (word line, WL), a bit line (bit line, BL), and a source line (source line, SL). Each memory cell 400 is electrically connected to a corresponding WL, BL, and SL. Different memory cells 400 may be electrically connected via WLs, BLs, and SLs. One or more of the WL, the BL, and the SL are configured to select a memory cell to be read/written in the memory array by receiving a control level output by a control circuit, to implement a data reading/writing operation.

The controller 32 in the memory may include one or more circuit structures in a decoder 320, a driver 330, a timing controller 340, a buffer 350, or an input/output driver 360 shown in FIG. 3.

In a structure of the memory 300 shown in FIG. 3, the decoder 320 is configured to perform decoding based on a received address, to determine a memory cell 400 to be accessed. The driver 330 is configured to control a level of a signal line based on a decoding result generated by the decoder 320, to implement access to a specified memory cell 400. The buffer 350 is configured to buffer read data, for example, may buffer the data in a first-in first-out (first-in first-out, FIFO) manner. The timing controller 340 is configured to control timing of the buffer 350, and control the driver 330 to drive a signal line in the memory array 31. The input/output driver 360 is configured to drive a transmission signal, for example, drive a received data signal and drive a data signal to be sent, so that the data signals can be transmitted over long distances.

The memory array 31, the decoder 320, the driver 330, the timing controller 340, the buffer 350, and the input/output driver 360 may be integrated into one chip, or may be integrated into a plurality of chips.

The memory 300 in this embodiment of this application may be a dynamic random access memory (dynamic random access memory, DRAM). For example, FIG. 4 is a diagram of a structure of a memory cell of a DRAM, including a transistor T0 and a capacitor C. A first end of the transistor T0 is connected to a BL, a second end of the transistor T0 is connected to a first end of the capacitor C, a control end of the transistor T0 is connected to a WL, and a second end of the capacitor C is connected to an SL and may be connected to a specific voltage (for example, a ground voltage) via the source line SL. The capacitor C is configured to store data. For example, when a voltage at the first end of the capacitor C is a high level and a voltage at the second end is a low level, 1 is stored. When a voltage at the first end of the capacitor C is a low level and a voltage at the second end is a high level, 0 is stored.

In this embodiment of this application, an N-channel metal oxide semiconductor (N-channel metal oxide semiconductor, NMOS) field effect transistor or a P-channel metal oxide semiconductor (P-channel metal oxide semiconductor, PMOS) field effect transistor may be selected as a transistor. One of a drain (drain) or a source (source) of the transistor is referred to as a first terminal, the other is referred to as a second terminal, and a control end of the transistor is a gate. The drain and the source of the transistor may be determined based on a flow direction of a current. The transistor T0 shown in FIG. 4 is used as an example. When the current is from left to right, the first terminal on the left side shown in FIG. 4 is the source, and the second terminal on the right side is the drain. On the contrary, when the current is from right to left, the second terminal on the right side is the source, and the first terminal on the left side is the drain.

The memory cell of the DRAM includes one transistor and one capacitor, and therefore is also referred to as a memory cell with a single-transistor single-capacitor (1 transistor 1 capacitor, 1T1C) structure. The memory cell of the DRAM may alternatively have a 2T1C or 2T2C structure or the like. Because the capacitor is used to store information in the memory cell of the DRAM, a manufacturing process is complex, and it is not conducive to increasing a storage density through stacking.

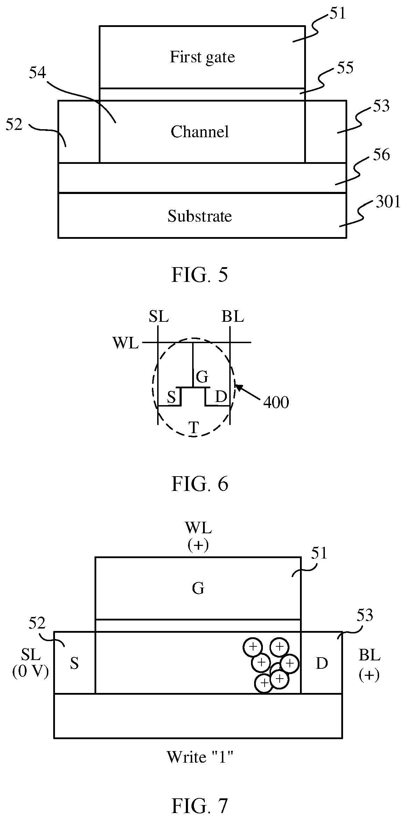

Embodiments of this application provide a floating body (floating body cell, FBC) DRAM. A floating body is a transistor formed by disposing silicon (Si) on an insulator based on a floating body effect (floating body effect), and is also referred to as a floating body effect transistor or a floating body cell. Refer to FIG. 5. For example, an oxide layer is provided between top silicon and a bottom substrate, and the oxide layer separates a floating body effect transistor from the bottom substrate. Such a technology is also referred to as silicon on insulator (Si on insulator, SOI). In subsequent descriptions of embodiments of this application, the floating body effect transistor is briefly referred to as a transistor. In other words, the transistor mentioned in the subsequent descriptions of embodiments of this application is the floating body effect transistor.

The transistor formed by using SOI forms a capacitor relative to the insulation substrate, charges may be accumulated on the capacitor, and the transistor may be configured to store 0 or 1. The transistor formed based on the floating body effect is a basic memory cell of the floating body DRAM. The memory cell of the floating body DRAM is formed by a single transistor. The transistor includes a first gate 51, a first terminal 52, a second terminal 53, and a channel 54 (channel) between the first terminal 52 and the second terminal 53 that are formed on a substrate 301. The first gate 51 covers the channel 54. An oxide layer 56 is disposed on the substrate 301, and the oxide layer 56 separates the substrate 301 from the first terminal 52, the second terminal 53, the channel 54, and the like, a gate oxide dielectric layer 55 is disposed between the first gate 51 and the channel 54 to separate the first gate 51 from the channel 54. The channel 54 is disposed in a direction parallel to the substrate 301. Therefore, a transistor formed in this way is referred to as a horizontal channel transistor. If the channel is disposed in a direction perpendicular to the substrate, a transistor formed in this way is referred to as a vertical channel transistor.

FIG. 6 is a schematic of a circuit of a memory cell 400 of a floating body DRAM. The memory cell includes a transistor T. A first terminal of the transistor T may be connected to an SL, a second terminal of the transistor T may be connected to a BL, and a first gate of the transistor T may be connected to a WL. In this way, data may be written into the memory cell by controlling voltages on the SL, the BL, and the WL, or stored data may be read by reading a current between a source and a drain.

In the memory cell shown in FIG. 6, the SL may also be referred to as a first control line for applying a signal to the first terminal of the transistor, the BL may also be referred to as a second control line for applying a signal to the second terminal of the transistor, and the WL may also be referred to as a third control line for applying a signal to the first gate of the transistor.

For example, a procedure of writing information into a memory cell of a floating body DRAM is first described. An example in which the first terminal of the transistor is a source, and the second terminal is a drain is used. Refer to FIG. 7. A voltage of the source is used as a reference voltage. For example, the source may be grounded (the voltage is 0 V), and a high positive voltage is applied to the first gate via the WL, and to the drain via the BL. In a small-sized device, a low source-drain voltage may form a strong horizontal electric field that is in the same direction as the channel near the drain. Due to an effect of the horizontal electric field, channel electrons obtain a large drift speed and energy in a strong field region near the drain, and become hot carriers. Some of the hot carriers collide with silicon atoms near the drain and are ionized to generate an electron hole pair, some of holes are applied to the substrate by a vertical electric field that is directed from the first gate to the substrate, to form a substrate current. Due to existence of the oxide layer, the substrate current cannot be released, and the holes are accumulated in the floating body. Therefore, this state may be defined as writing 1. Hole accumulation results in a decrease in a threshold voltage (Vₜₕ) of the transistor, so that the transistor is more likely to be conducted.

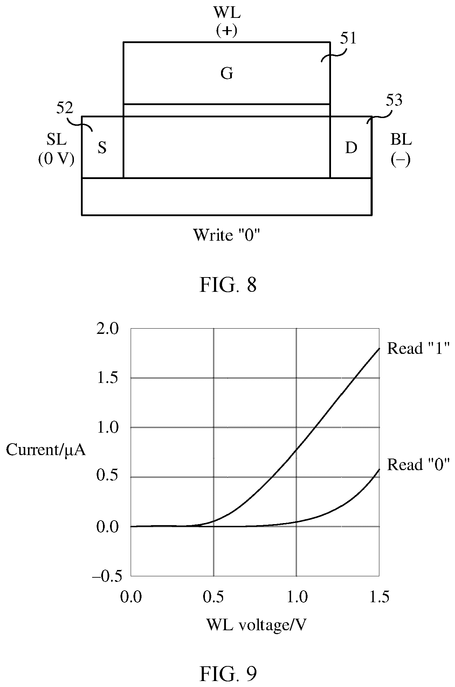

Refer to FIG. 8. When a positive voltage is applied to the WL, and a voltage of the BL changes to a negative voltage, a hole may be emitted from a floating body, so that a threshold voltage (Vₜₕ) of a transistor increases, and is restored to an initial state. This state may be defined as writing 0.

Charge accumulation changes the threshold voltage (Vₜₕ) of the transistor. In the two states of writing 0 and writing 1, the threshold voltages (Vₜₕ) of the transistor are different. Therefore, a difference between the threshold voltages of the transistor in the two different states may be sensed by using currents flowing through the transistor in the two states, to complete a reading operation.

Because the threshold voltage (Vₜₕ) of the transistor decreases in the state of writing 1 and the transistor is more likely to be conducted, and the threshold voltage (Vₜₕ) of the transistor increases in the state of writing 0 and the transistor is more difficult to be conducted, when a reading voltage is applied to the transistor, for example, with reference to FIG. 9, when a current between the source and the drain of the transistor is large, 1 is read; and when a current between the source and the drain of the transistor is small, 0 is read.

The memory cell of the floating body DRAM needs only one transistor to store 0 or 1, and a DRAM with a 1T0C structure may be formed. Compared with a conventional DRAM with a 1T1C structure or the like, a structure and a manufacturing process of the floating body DRAM are simpler. However, a storage density of the DRAM with the 1T1C structure may reach 4 GB/100 mm², and a storage density of the existing floating body DRAM is low, and cannot reach the storage density of the DRAM with the 1T1C structure.

There are mainly two types of typical memory cells of the floating body DRAM. For example, the transistor of the memory cell of the floating body DRAM may have a horizontal channel structure, or the transistor of the memory cell of the floating body DRAM may have a vertical channel structure.

The horizontal channel transistor means that the channel of the transistor is parallel to the substrate. As shown in FIG. 5, the channel of the transistor is located between the source and the drain, and the channel disposed in parallel to the substrate occupies a large area, and the formed floating body DRAM has a low storage density.

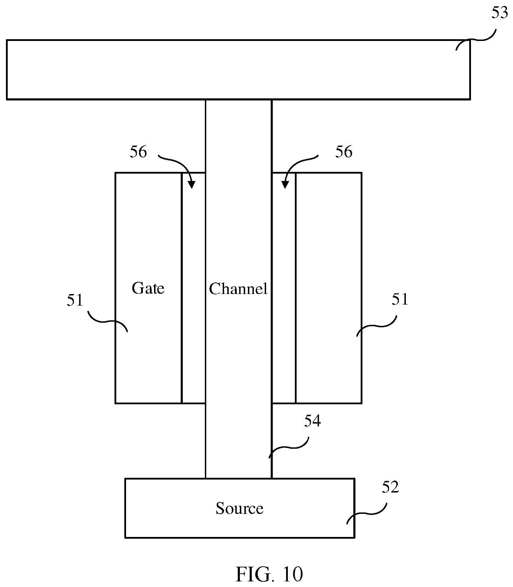

Refer to FIG. 10. The transistor of the memory cell of the floating body DRAM may alternatively have a vertical channel structure, and the channel 54 is perpendicular to the substrate. In this way, an area occupied by a single memory cell can be reduced. However, a manufacturing process of the vertical channel floating body cell is difficult. In addition, although the area occupied by the single floating body cell is reduced, a spacing between adjacent memory cells cannot be less than 40 nm due to a process limitation, which also causes a low storage density of the floating body DRAM.

To alleviate a problem of a low storage density of a floating body DRAM, embodiments of this application provide a memory array, including a plurality of memory layers. The memory layers include a plurality of memory cells. The memory cell includes a single transistor formed based on a floating body effect. The plurality of memory layers are stacked in a direction perpendicular to a substrate, to increase the storage density of the floating body DRAM.

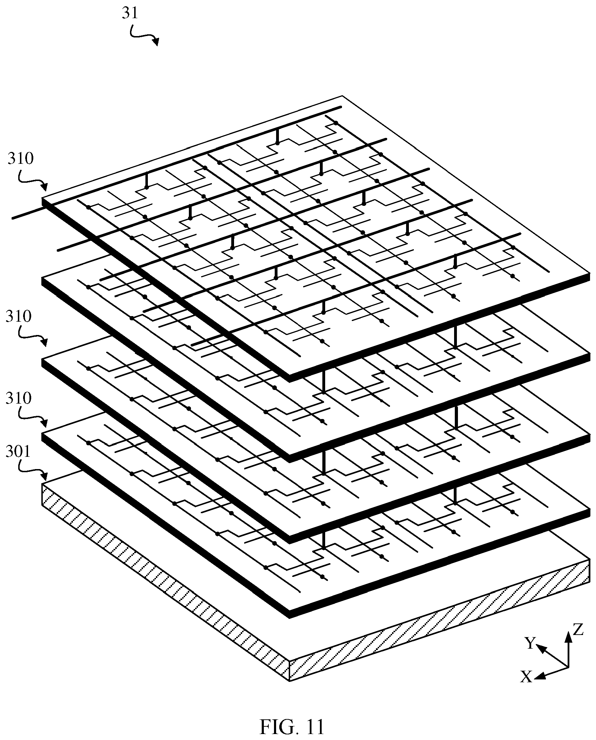

For example, FIG. 11 is a schematic of a circuit of a memory array 31 according to an embodiment of this application. The memory array 31 includes a substrate 301 and a plurality of memory layers 310 formed on the substrate. The plurality of memory layers are stacked in a first direction perpendicular to the substrate. The first direction may be a Z direction shown in the figure. The memory layers may be stacked to increase a storage density.

The memory layer includes a plurality of memory cells, first control lines, second control lines, and third control lines. For example, the memory cell provided in this embodiment of this application includes a floating body cell. The floating body cell is a transistor formed based on a floating body effect, and may be configured to store data. The memory cell includes a transistor. With reference to FIG. 5, the transistor includes a first gate, a first terminal, a second terminal, and a channel located between the first terminal and the second terminal. The channel is disposed in a second direction parallel to the substrate. The second direction herein may be an X direction shown in the figure. A gate oxide dielectric layer is disposed between the first gate and the channel to separate the first gate from the channel.

The first terminal of the transistor is connected to the first control line, the second terminal is connected to the second control line, and the first gate is connected to the third control line. For example, a signal may be applied to a selected memory cell by using the first control line, the second control line, and the third control line, to write data or read data stored in the memory cell.

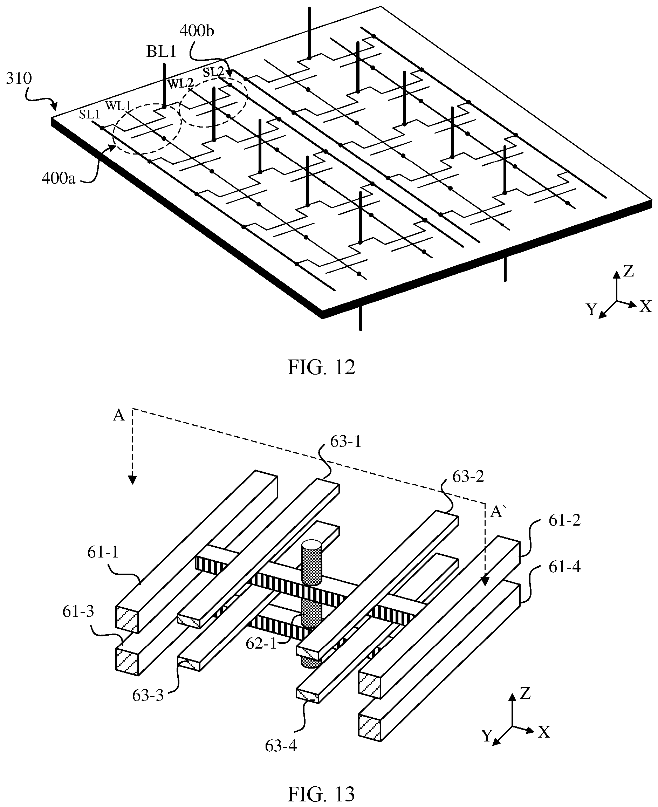

For example, FIG. 12 is a schematic of a circuit of a memory layer. In the memory layer shown in FIG. 12, it may be understood with reference to FIG. 6 that the first terminal of the transistor is connected to the SL. For example, a first terminal of a transistor of a memory cell 400a is connected to an SL1, a second terminal is connected to a BL1, and a first gate is connected to a WL1. A first terminal of a transistor of a memory cell 400b is connected to an SL2, a second terminal is connected to the BL1, and a first gate is connected to a WL2.

The following describes, with reference to an example, a possible structure of the memory array provided in embodiments of this application.

For example, with reference to FIG. 13, a memory array shown in FIG. 13 includes two memory layers, and each memory layer displays that two memory cells 400 are included. The structure of the memory array shown in FIG. 13 is merely used as an example for description. The memory array may alternatively include more memory layers, and each memory layer may alternatively include more memory cells.

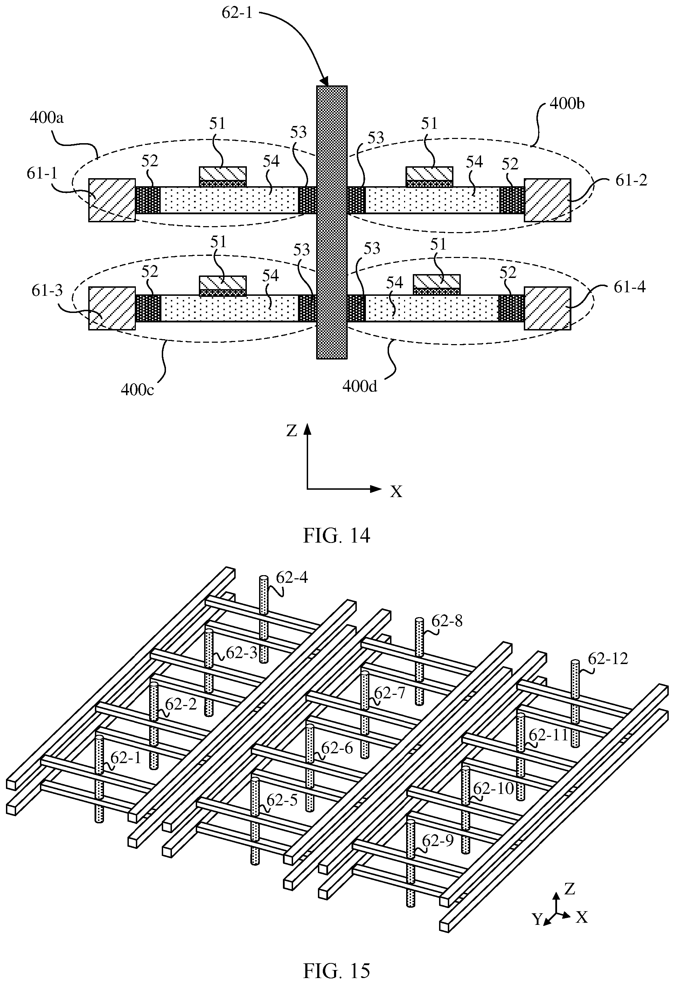

For example, with reference to FIG. 13 and FIG. 14, FIG. 14 is a cutaway view of the memory array shown in FIG. 13 in an A-A' direction. The memory array shown in FIG. 13 and FIG. 14 includes four memory cells 400, which are respectively a first memory cell 400a, a second memory cell 400b, a third memory cell 400c, and a fourth memory cell 400d.

A transistor of a memory cell includes a first gate 51, a first terminal 52, a second terminal 53, and a channel 54 located between the first terminal 52 and the second terminal 53. The channel 54 is disposed in a second direction parallel to a substrate, and the second direction herein may be an X direction shown in the figure.

The memory array further includes a first control line structure, a second control line structure, and a third control line structure, for example, first control line structures 61-1, 61-2, 61-3, and 61-4 shown in FIG. 13 and FIG. 14, a second control line structure 62-1, third control line structures 63-1, 63-2, 63-3, and 63-4. The second control line structure 62-1 extends in a first direction, that is, extends in a direction perpendicular to the substrate, and the plurality of memory layers are stacked in the direction perpendicular to the substrate. Therefore, it may be considered that second control line structures of different memory layers are connected. For example, a second control line structure of a first memory layer and a second control line structure of a second memory layer are distributed in the first direction, and second control line structures of different memory layers distributed in the first direction are connected together, to form one integrated second control line perpendicular to the substrate.

In embodiments of this application, the first control line, the second control line, the third control line, and the like are logically distinguished, and each may represent a signal line. The first control line structure, the second control line structure, and the third control line structure are spatial structures, and each may represent a metal line parallel to or perpendicular to the substrate, or may include a combined structure of both a metal line parallel to the substrate and a metal line perpendicular to the substrate, or in other words, in this application, a spatial structure of the first control line is described as the first control line structure, a spatial structure of the second control line is described as the second control line structure, and a spatial structure of the third control line is described as the third control line structure. The control line and the control line structure are descriptions on a same object from different perspectives.

For example, the first control line structure forms the first control line, the second control line structure forms the second control line, and the third control line structure forms the third control line. For example, a first control line structure 61-1 forms a first control line 61-1, the second control line structure 62-1 may form a second control line BL1, and the third control line structure 63-1 may form a third control line 63-1. The first control line may be a source line, the second control line may be a bit line, and the third control line may be a word line.

The first terminal of the transistor is connected to the first control line structure, the second terminal is connected to the second control line structure, and the first gate is connected to the third control line. For example, with reference to FIG. 13 and FIG. 14, the first terminal 52 of the transistor of the memory cell 400a is connected to the first control line structure 61-1, the second terminal 53 is connected to the second control line structure 62-1, and the first gate 51 is connected to the third control line structure 63-1. The first terminal 52 of the transistor of the memory cell 400b is connected to the first control line structure 61-2, the second terminal 53 is connected to the second control line structure 62-1, and the first gate 51 is connected to the third control line structure 63-2.

The first control line structure extends in a third direction. For example, the first control line structures 61-1 to 61-4 in FIG. 13 extend in the third direction. The third direction is a direction parallel to the substrate and perpendicular to the second direction, for example, may be a Y direction shown in the figure. For example, in embodiments of this application, distribution in the second direction is referred to as one row, distribution in the third direction is referred to as one column, the first control line structure extends in the third direction, and the first control line structure is connected to first terminals of a plurality of transistors distributed in the third direction. In other words, first terminals of transistors in a same column are connected to a same first control line structure.

The second control line structure extends in the first direction. For example, the second control line structure 62-1 shown in FIG. 13 and FIG. 14 extends in the first direction, and the first direction is perpendicular to the substrate, for example, may be a Z direction shown in the figure. The second control line structure is connected to the second terminal of the transistor distributed in the first direction. For example, as shown in FIG. 14, the second control line structure 62-1 is connected to the second terminal 53 of the transistor of the memory cell 400a and the second terminal 53 of the transistor of the memory cell 400c.

The third control line structure may also extend in the third direction. For example, the third control line structures 63-1 to 63-4 shown in FIG. 13 extend in the third direction. The third control line structure is connected to the first gate of the transistor distributed in the third direction, or in other words, memory cells in a same column are connected to a same third control line structure.

In the memory array provided in this embodiment of this application, each memory cell is connected to the third control line structure extending in the third direction, is connected to the second control line structure extending in the first direction, and is further connected to the first control line structure extending in the third direction. An extension direction of the first control line structure is perpendicular to an extension direction of the second control line structure, and the extension direction of the second control line structure is also perpendicular to an extension direction of the third control line structure. The memory cell is located at an intersection between the first control line structure and the second control line structure. Therefore, any one or a specified memory cell in the memory array may be positioned by using the first control line, the second control line, and the third control line, and data is written into the specified memory cell or data stored in the memory cell is read.

The memory array provided in this embodiment of this application includes the plurality of memory layers, and the plurality of memory layers are stacked in the first direction perpendicular to the substrate, to increase the storage density. The memory layer provided in this embodiment of this application includes the plurality of memory cells, and each memory cell includes only one transistor. For another type of DRAM, for example, a DRAM with a 1T1C or 2T1C structure or the like, a memory cell of the DRAM includes at least one capacitor, and a thickness of the capacitor is large, which is not conducive to stacking of memory cells in the direction perpendicular to the substrate. Therefore, compared with another DRAM with the 1T1C or 2T1C structure or the like, the memory array formed by the floating body cell provided in this embodiment of this application has a single memory cell with a smaller size and has a simpler manufacturing process, and the storage density can be increased by stacking the memory layers in the direction perpendicular to the substrate.

For example, the plurality of memory cells at the memory layer may be disposed in a form of a memory cell group. Each memory cell group includes two memory cells: a first memory cell and a second memory cell. The first memory cell and the second memory cell are distributed in the second direction parallel to the substrate.

For example, one memory layer may include m rows and n columns of memory cell groups. Because each memory cell group includes two memory cells distributed in the second direction, one memory layer includes m rows and 2n columns of memory cells.

For example, the memory cell 400a is referred to as a first memory cell, the memory cell 400b is referred to as a second memory cell, the memory cell 400c is referred to as a third memory cell, and the memory cell 400d is referred to as a fourth memory cell. The first memory cell 400a and the second memory cell 400b are used as an example. The second terminal 53 of the transistor of the first memory cell 400a faces the second memory cell 400b, the second terminal 53 of the transistor of the second memory cell 400b faces the first memory cell 400a, the second terminal 53 of the transistor of the first memory cell 400a is connected to the second terminal 53 of the transistor of the second memory cell 400b, and the first memory cell 400a and the second memory cell 400b form a memory cell group. In such a memory cell group, second terminals of transistors of two memory cells are connected together. Therefore, the second terminals of the two transistors in the memory cell group may be connected to a same second control line structure. For example, both the first memory cell 400a and the second memory cell 400b are connected to the second control line structure 62-1. In this way, a quantity of required second control lines can be reduced.

In some possible implementations, the second terminal 53 of the transistor of the first memory cell 400a and the second terminal 53 of the transistor of the second memory cell 400b are integrated. In other words, the second terminal 53 of the transistor of the first memory cell 400a and the second terminal 53 of the transistor of the second memory cell 400b share a same common electrode, and are connected to a same second control line structure, for example, the second control line structure 62-1 shown in FIG. 13 to FIG. 15. The second control line structure extends in the first direction perpendicular to the substrate, and the second control line structure (for example, the second control line structure 62-1 shown in FIG. 13 or FIG. 14) extending in the direction perpendicular to the substrate may pass through the common electrode. In this way, both the second terminal 53 of the transistor of the first memory cell 400a and the second terminal 53 of the transistor of the second memory cell 400b are connected to the second control line structure.

The third memory cell 400c and the fourth memory cell 400b are distributed in the second direction, the third memory cell 400c and the first memory cell 400a are distributed in the first direction, the fourth memory cell 400d and the second memory cell 400b are distributed in the first direction, the second terminal 53 of the transistor of the third memory cell 400c is connected to the second terminal 53 of the transistor of the fourth memory cell 400d, and the third memory cell 400c and the fourth memory cell 400b form a memory cell group. In addition, because the second control line structure 62-1 extends in the first direction, the first memory cell 400a and the third memory cell 400c that are distributed in the first direction are connected to the same second control line structure 62-1, and the second memory cell 400b and the fourth memory cell 400d that are distributed in the first direction are connected to the same second control line structure 62-1. In this way, it is equivalent to describing that a memory cell group distributed in the first direction is connected to the same second control line.

According to the memory array provided in this embodiment of this application, the storage density can be increased in a form of stacking the memory layers. At the memory layer, memory cells are arranged in the form of the memory cell group. The memory layer may include m rows and n columns of memory cell groups. The memory cell group includes the first memory cell and the second memory cell. The second terminal of the transistor of the first memory cell is close to the second memory cell, the second terminal of the transistor of the second memory cell is close to the first memory cell, and the second terminal of the transistor of the first memory cell and the second terminal of the transistor of the second memory cell are connected to the same second control line structure, so that the quantity of second control lines in the memory array can be reduced. In addition, the second terminal of the transistor of the first memory cell and the second terminal of the transistor of the second memory cell may alternatively be integrated, so that an area occupied by each memory cell group can be reduced, that is, an area of the memory cell is reduced. In this way, on one hand, the quantity of second control lines in the memory array is reduced, and on the other hand, the area occupied by each memory cell group is reduced, so that the size of the memory array can be reduced, and the storage density can be increased.

In the foregoing example, different memory layers in the first direction may be connected by using the second control line structure extending in the first direction, and the second control line structure extending in the first direction is perpendicular to the substrate. Although the plurality of memory layers may share the second control line structure, because two memory cells in each memory cell group in one memory layer are connected to one second control line, if one memory layer includes m*n memory cell groups, the memory array needs m*n second control lines. For example, FIG. 15 is a diagram of a memory array according to an embodiment of this application. The memory array includes two memory layers. Each memory layer includes four rows and three columns of memory cell groups, that is, four rows and six columns of memory cells. To intuitively display setting of the second control line structures, the third control line structure is not shown in the memory array shown in FIG. 15. Each memory cell group is connected to one second control line structure. The memory array needs to be provided with 12 second control line structures 62-1 to 62-12 in total, that is, 12 second control line interconnects need to be routed out. When a memory is formed, such a large quantity of interconnects increases a quantity of address resolution circuit interfaces of the memory and enlarges an area.

For example, in the memory array provided in this embodiment of this application, the second control line structure includes a horizontal control line and a vertical control line, the vertical control line of the second control line structure extends in the first direction, the horizontal control line of the second control line structure extends in the second direction, and the horizontal control line of the second control line structure is connected to a plurality of vertical control lines distributed in the second direction, or a plurality of vertical control lines extending in the first direction may be routed out by using one horizontal control line extending in the second direction parallel to the substrate, to reduce a quantity of interconnects to be routed out.

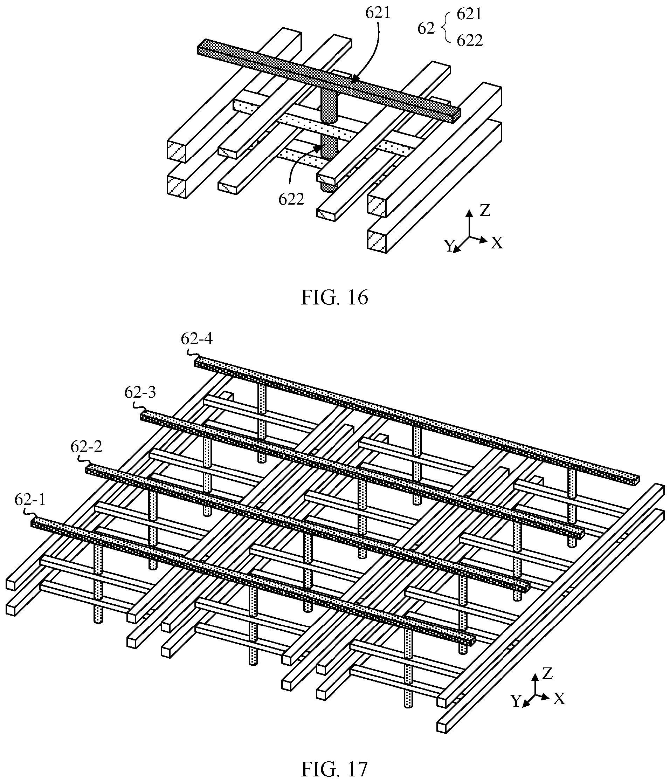

For example, with reference to FIG. 16 and FIG. 17, a second control line structure 62 is used as an example. The second control line structure 62 includes a horizontal control line 621 and a vertical control line 622. In this embodiment of this application, distribution in the second direction is referred to as one row, and distribution in the third direction is referred to as one column. At one memory layer, each memory cell group corresponds to one vertical control line 622 that is of the second control line structure and that is perpendicular to the substrate. In this case, each row of memory cell groups corresponds to a plurality of vertical control lines 622 of the second control line structure, and the plurality of vertical control lines 622 of the second control line structure distributed in the second direction may be referred to as one row of vertical control lines 622. In the solution provided in this embodiment of this application, one horizontal control line 621 extending in the second direction is used to connect ends of the row of vertical control lines 622 away from the substrate, and the plurality of vertical control lines 622 distributed in the second direction are connected to the same horizontal control line 621. In this way, the horizontal control line 621 and the row of vertical control lines 622 connected to the horizontal control line 621 jointly form one integrated second control line structure, which is equivalent to describing that all memory cells on a same XZ plane are connected to a same second control line structure. Therefore, signal statuses of the plurality of vertical control lines 622 of the second control line structure 62 can be controlled only by routing out an interconnect from the horizontal control line 621 of the second control line structure 62, to greatly reduce a quantity of interconnects or interfaces.

For example, with reference to FIG. 17, compared with the memory array shown in FIG. 15, the memory array shown in FIG. 15 needs to be provided with 12 second control line structures, that is, 12 second control lines need to be routed out, and the array shown in FIG. 17 needs to be provided with only four second control line structures 62-1 to 62-4, that is, only four second control lines need to be routed out.

According to the memory array provided in this embodiment of this application, the plurality of memory layers are stacked in the direction perpendicular to the substrate to increase the storage density. The second terminal of the transistor of the first floating body cell and the second terminal of the transistor of the second floating body cell in the memory cell group are connected to the same second control line structure. In this way, the quantity of second control line structures required by the memory array can be reduced. In addition, in the solution provided in this embodiment of this application, the second control line structure includes the horizontal control line and the vertical control line, one horizontal control line extending in the second direction is used to connect ends of one row of vertical control lines away from the substrate, and the signal statuses of the plurality of vertical control lines can be controlled only by routing out the interconnect from the horizontal control line, to greatly reduce the quantity of interconnects or interfaces and reduce a size of the memory.

In the memory array, the first gate of the transistor of the memory cell is connected to the third control line structure, the third control line structure extends in the third direction, and the third control line structure is connected to first gates of a plurality of transistors of memory cells distributed in the third direction. In other words, each third control line structure may control conduction statuses of a plurality of transistors of one column of memory cells distributed in the third direction.

For the entire memory array, if each memory layer includes m rows and n columns of memory cell groups, because each memory cell group includes two memory cells distributed in the second direction, 2n third control line structures need to be routed out at each memory layer. If the memory array includes p stacked memory layers, the memory array needs to route out p*2n third control line structures in total.

To reduce a quantity of third control line structures that are routed out, the third control line structure provided in this embodiment of this application may also be set in a form similar to that of the second control line structure. The third control line structure includes a vertical control line extending in the direction perpendicular to the substrate and a horizontal control line extending in the direction parallel to the substrate. For example, the horizontal control line of the third control line structure may extend in the second direction or the third direction. In this way, the horizontal control line of the third control line structure may be connected to a plurality of vertical control lines distributed in the second direction, or may be connected to a plurality of vertical control lines distributed in the third direction.

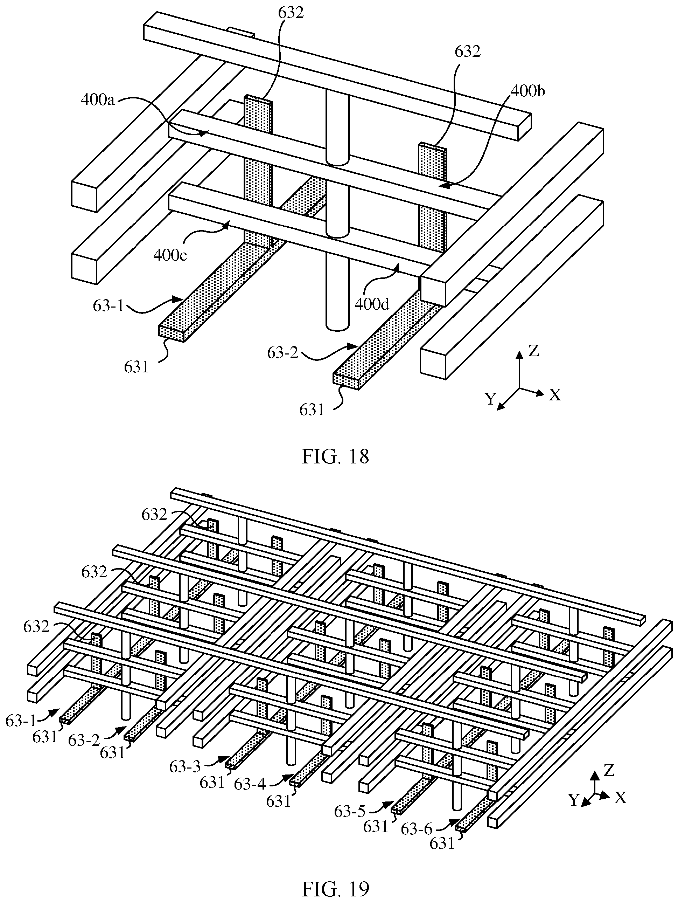

For example, an embodiment of this application further provides another memory array. Refer to FIG. 18. In the memory array, the third control line structure also includes the vertical control line extending in the first direction and the horizontal control line extending in the direction parallel to the substrate. The horizontal control line of the third control line structure may be connected to the plurality of vertical control lines of the third control line structure. A vertical control line of the third control line structure may be connected to first gates of transistors of a plurality of memory cells distributed in the first direction.

For example, the third control line structure 63-1 includes a horizontal control line 631 extending in the horizontal direction and a vertical control line 632 extending in the direction perpendicular to the substrate. The vertical control line 632 may be connected to the first gate of the transistor distributed in the first direction. For example, first gates of transistors of a first memory cell 400a and a third memory cell 400c shown in FIG. 18 are connected to the vertical control line 632 of the third control line structure 63-1, and first gates of transistors of a second memory cell 400b and a fourth memory cell 400d are connected to a vertical control line 632 of a third control line structure 63-2.

The third control line structure may include a plurality of vertical control lines. The plurality of vertical control lines of the third control line structure are distributed in the third direction, and are in the same extension direction as the horizontal control line of the third control line structure. In this way, the vertical control lines of the third control line structure may be connected to the horizontal control line, and signals may be applied to the plurality of vertical control lines by using the horizontal control line, to reduce a quantity of interconnects to be routed out.

For example, with reference to FIG. 19, a memory array shown in FIG. 19 includes three rows and three columns of memory cell groups, that is, three rows and six columns of memory cells, and six third control line structures need to be routed out in total, for example, third control line structures 63-1 to 63-6 shown in FIG. 19.

In addition, the third control line structure 63-1 is used as an example. The third control line structure 63-1 may include a plurality of vertical control lines 632, the plurality of vertical control lines 632 are distributed in the third direction, the horizontal control line 631 extends in the third direction, and the plurality of vertical control lines 632 are connected to the horizontal control line 631.

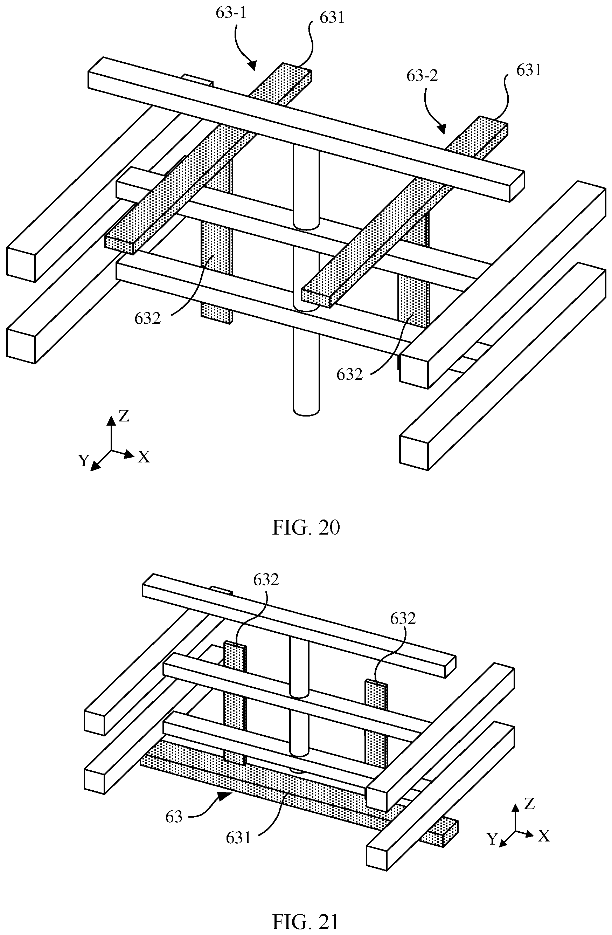

In the foregoing example, for example, with reference to FIG. 18 and FIG. 19, the horizontal control line of the third control line structure may be connected to an end that is of the vertical control line of the third control line structure and that is close to the substrate. Alternatively, with reference to FIG. 20, in another possible implementation, the horizontal control line of the third control line structure may be alternatively connected to an end that is of the vertical control line of the third control line structure and that is away from the substrate. For example, the horizontal control line 631 of the third control line structure 63-1 is located on a side away from the substrate, and the horizontal control line 631 of the third control line structure is connected to an end that is of the vertical control line 632 of the third control line structure and that is away from the substrate.

In addition, in the foregoing example, the horizontal control line of the third control line structure extends in the third direction, and the horizontal control line of the third control line structure extending in the third direction may connect one column of vertical control lines distributed in the third direction to form one integrated third control line structure. In this case, first gates of transistors of all memory cells distributed on a same YZ plane are connected to a same third control line structure. If the memory array includes p stacked memory layers, and each memory layer includes m rows and n columns of memory cell groups, only n third control line structures need to be disposed in the entire memory array, that is, n third control lines need to be disposed. If the third control line structure is connected to only one column of memory cells, p*2n third control line structures need to be disposed in total in the memory array, that is, p*2n third control systems need to be disposed. It can be learned that, in the solution provided in this embodiment of this application, a quantity of third control line structures that need to be disposed in the memory array can be greatly reduced.

In some other possible implementations, the horizontal control line of the third control line structure may alternatively extend in the second direction (the X direction shown in the figure). For example, with reference to FIG. 21, the horizontal control line 631 of the third control line structure 63 extends in the second direction, and the vertical control line 632 extends in the first direction (the Z direction shown in the figure). The plurality of vertical control lines 632 distributed in the second direction and the horizontal control line 631 extending in the second direction are connected to form one integrated third control line structure 63. In this case, all memory cells distributed in a same XZ plane are connected to a same third control line structure 63, which can also greatly reduce the quantity of third control line structures to be routed out in the memory array.

According to the memory array provided in this embodiment of this application, the plurality of memory layers are stacked in the direction perpendicular to the substrate to increase the storage density, and the third control line structure includes the horizontal control line extending in the direction parallel to the substrate and the vertical control line extending in the direction perpendicular to the substrate. One row of vertical control lines of the third control line structure distributed in the second direction may be routed out by using one horizontal control line, or one column of vertical control lines of the third control line structure distributed in the third direction may be routed out by using one horizontal control line, to reduce the quantity of interconnects to be routed out, reduce space occupied by the memory array, and increase the storage density.

With the development of a process flow, a size of a transistor becomes smaller. As a result, a short-channel effect becomes more obvious. The short-channel effect means that a spacing between a drain and a source of a transistor is continuously reduced, and a contact area between a first gate and a channel is also increasingly small. It is difficult for the first gate to exhaust carriers in the channel, a control capability on the channel is continuously weakened, a leakage current of the transistor increases, static power consumption increases, and performance deteriorates.

To alleviate the foregoing problem, in the memory array provided in this embodiment of this application, the first gate of the transistor of the memory cell may include a plurality of different structures, to improve the control capability of the first gate on the channel. In a possible implementation, the first gate of the transistor of the memory cell may have a dual-electrode structure, the first gate of the transistor of the memory cell includes a first electrode and a second electrode that are opposite to each other, and the channel is located between the first electrode and the second electrode.

The first gate of the transistor shown in FIG. 5 includes only one electrode, and a contact area between the electrode and the channel is limited. The first gate of the transistor of the memory cell provided in this embodiment of this application includes the first electrode and the second electrode that are opposite to each other, the channel is located between the first electrode and the second electrode, and either of the first electrode and the second electrode may have the same size as a separate first gate of a conventional memory cell. In this way, the first gate with the dual-electrode structure may double a contact area or an orthogonal projection area between the first gate and the channel, to enhance the control capability of the first gate on the channel, and improve performance of the transistor.

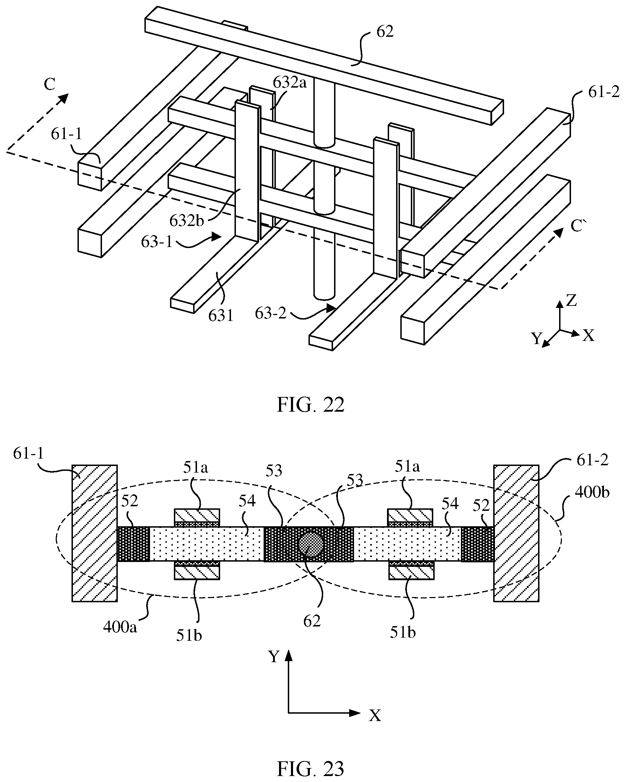

For example, with reference to FIG. 22 and FIG. 23, FIG. 22 is a diagram of a memory array according to an embodiment of this application, and FIG. 23 is a cutaway view of the memory array shown in FIG. 22 in a C-C' direction.

For example, the first gate of the transistor includes the first electrode and the second electrode that are opposite to each other. For example, the first gate 51 of the transistor of the first memory cell 400a shown in FIG. 22 includes a first electrode 51a and a second electrode 51b. The first gate 51 of the transistor of the second memory cell 400b includes a first electrode 51a and a second electrode 51b, and the first electrode 51a and the second electrode 51b are disposed on two sides of the channel 54, to increase a contact area between the first gate 51 and the channel 54, enhance a control capability of the first gate 51 on the channel 54, and improve performance of the transistor.

In addition, with reference to FIG. 19, a first gate of a transistor of each memory cell in the memory array shown in FIG. 19 may have a dual-electrode structure.

Because the first gate of the transistor of the memory cell is connected to the third control line structure, when the first gate has two electrodes, the third control line structure may also be formed by two electrode lines, and the two electrode lines are connected to a same signal.

For example, as shown in FIG. 22, the third control line structure 63-1 includes a horizontal control line 631 and a vertical control line 632, and the vertical control line 632 is connected to first gates of transistors of a plurality of memory cells distributed in the first direction. If the first gate of the transistor of the memory cell has the dual-electrode structure, the vertical control line 632 may also exist in a form of paired electrode lines. For example, with reference to FIG. 22 and FIG. 23, the vertical control line 632 of the third control line structure 63-1 includes a first electrode line 632a and a second electrode line 632b, the first electrode line 632a is connected to first electrodes 51a of first gates 51 of transistors of a plurality of memory cells distributed in the first direction, the second electrode line 632b is connected to second electrodes 51b of the first gates 51 of the transistors of the plurality of memory cells distributed in the first direction, and the first electrode line 632a and the second electrode line 632b are connected to a same horizontal control line 631.

In the memory array shown in FIG. 22, the horizontal control line of the third control line structure may extend in the third direction. In another possible implementation of this application, the horizontal control line of the third control line structure may alternatively extend in the second direction.

The first gate is set as the dual-electrode structure, so that the contact area between the first gate of the transistor of the memory cell and the channel can be increased, and the control capability of the first gate on the channel can be enhanced.

For example, in another possible implementation, the first gate of the transistor of the memory cell may alternatively have a gate-all-around, that is, the first gate of the transistor of the memory cell is disposed around the channel.

For example, based on the diagrams of structures of the memory array shown in FIG. 22 and FIG. 23, when the first electrode 51a and the second electrode 51b of the first gate 51 are integrated, and surround the channel 54, a ring-shaped first gate structure is formed. In this case, two electrode lines do not need to be disposed for the vertical control line of the third control line structure, and only one electrode line needs to be disposed to connect to the ring-shaped first gate of the transistor distributed in the first direction.

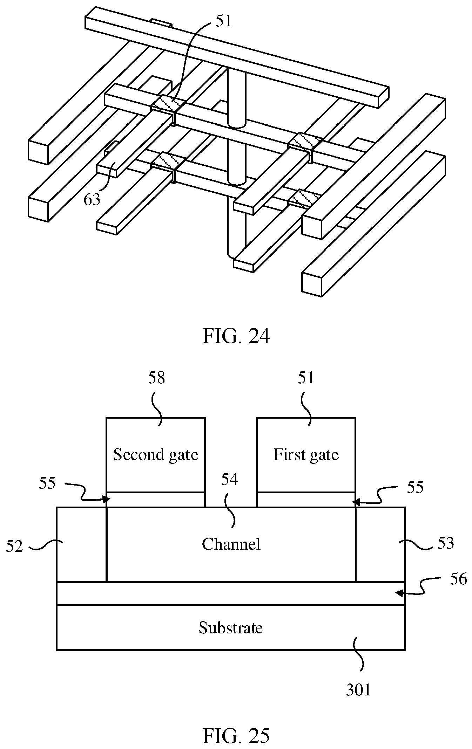

Alternatively, FIG. 24 is a diagram of another memory array according to an embodiment of this application. In the memory array, the first gate 51 of the transistor of the memory cell is disposed around the channel, and the third control line structure 63 may extend in the horizontal third direction, and is connected to first gates 51 of transistors of a plurality of memory cells distributed in the third direction.

As mentioned in the foregoing example, a reference voltage (for example, the reference voltage may be 0 V) is applied to the first terminal (for example, the source) of the floating body effect transistor by using the first control line, a positive voltage is applied to the gate of the floating body effect transistor by using the third control line, and a positive voltage is applied to the second terminal (for example, the drain) of the floating body effect transistor by using the second control line, so that a hole can be formed in the channel, and the hole (with a positive charge) is stored in the channel, that is, "1" is stored. Because a horizontal electric field is strong in a region near the drain, holes are accumulated on a side near the drain in the channel. During data storage, the holes may flow out from the drain, resulting in insufficient retention time of the stored data.

To alleviate a problem of insufficient retention time of data, an embodiment of this application provides another floating body memory. A transistor of a memory cell is set as a dual-gate structure, and includes two independent gates: a first gate and a second gate. The first gate and the second gate are distributed in an extension direction of a channel (for example, the second direction in embodiments of this application), and the first gate and the second gate do not contact each other. For example, the first gate and the second gate are separated by an insulation medium. Such a structure may increase retention time of data stored in the memory cell.

With reference to the accompanying drawings, the following describes a principle of the floating body memory provided in this embodiment of this application. FIG. 25 shows a memory cell of another floating body memory according to an embodiment of this application. The memory cell is formed by a single transistor, and the transistor is also referred to as a floating body cell. The transistor includes a first terminal 52, a second terminal 53, and a channel 54 between the first terminal 52 and the second terminal 53 that are formed on a substrate 301, and the transistor further includes a first gate 51 and a second gate 58. The channel 54 is disposed in a second direction, the first gate 51 and the second gate 58 are distributed in an extension direction of the channel, the first gate 51 is located on a side close to the second terminal 53, the second gate 58 is located on a side close to the first terminal 52, the first gate 51 and the second gate 58 separately cover a part of the channel, a gate oxide dielectric layer 55 is disposed between the first gate 51 and the channel 54 to separate the first gate 51 from the channel 54, a gate oxide dielectric layer 55 is disposed between the second gate 58 and the channel 54 to separate the second gate 58 from the channel 54, the first gate 51 and the second gate 58 may be separated by an insulation medium, and a material of the insulation medium herein may be the same as a material of the gate oxide dielectric layer 55.

The first terminal 52 may be connected to a first control line, the second terminal 53 may be connected to a second control line, the first gate 51 may be connected to a third control line, and the second gate may be connected to a fourth control line. Voltages may be applied to the memory cell by using the first control line, the second control line, the third control line, and the fourth control line, to implement reading and writing on the memory cell.

When applied to a DRAM, the first control line may be a source line (source line, SL), the second control line may be a bit line (bit line, BL), the third control line may be a word line (word line, WL), and the fourth control line may be a plate line (plate line, PL).

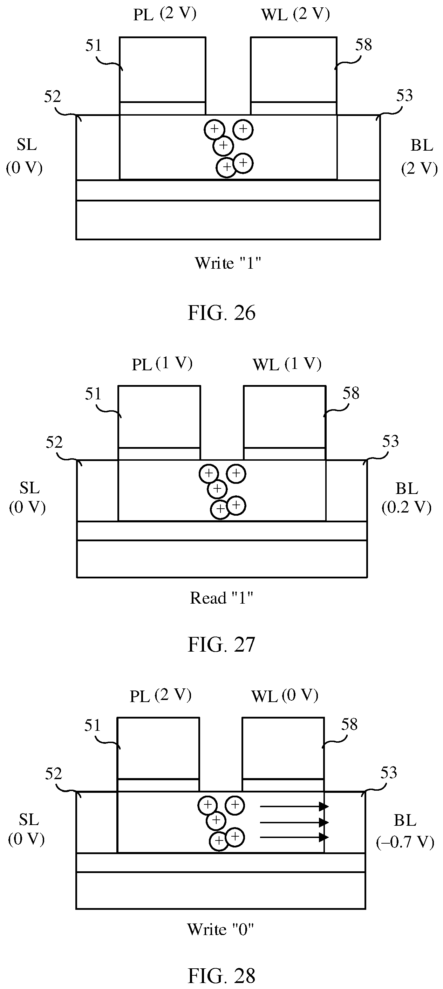

A procedure of writing data into the floating body cell with the dual-gate structure provided in this embodiment of this application is basically the same as a procedure of writing data into a conventional floating body cell. For example, with reference to FIG. 26, in an example in which the first terminal 52 is a source (source, S) and the second terminal 53 is a drain (drain, D), the first control line SL accesses 0 V, a voltage of the source is used as a reference voltage, a first voltage is applied to the first gate by using the third control line WL, the first voltage is applied to the second gate by using the fourth control line PL, the first voltage is applied to the drain by using the second control line BL, and the first voltage is a positive voltage. For example, the first voltage is 2 V. Applying the positive voltage to the first gate and the second gate may conduct the transistor. When the transistor is conducted, a low source-drain voltage may form a strong horizontal electric field that is in the same direction as the channel near the drain. Due to an effect of the horizontal electric field, channel electrons obtain a large drift speed and energy in a strong field region near the drain, and become hot carriers. Some of the hot carriers collide with silicon atoms near the drain and are ionized to generate an electron hole pair, and holes are accumulated in the channel. This state is defined as writing 1.

In addition, hole aggregation results in a decrease in a threshold voltage of the transistor, so that the transistor is more likely to be conducted. In the conventional floating body cell, when 1 is written, holes are accumulated in a region, in a channel, near a drain. However, in the floating body cell with the dual-gate structure provided in this embodiment of this application, with reference to FIG. 26, when 1 is written, because in the transistor with the dual-gate structure, an electric field of a channel region between a channel region in contact with the first gate and a channel region in contact with the second gate is stronger than an electric field of another region, in other words, the holes are accumulated between the channel region in contact with the first gate and the channel region in contact with the second gate, instead of a region near the source or the drain. In this way, a hole aggregation position is farther away from the source or the drain, and it is more difficult for charges to flow out of the source or the drain, so that retention time of stored data can be increased.

In addition, when data stored in the memory cell is read, with reference to FIG. 27, the first control line SL accesses 0 V, a second voltage is applied to the first gate by using the third control line WL, the second voltage is applied to the second gate by using the fourth control line PL, the second voltage is less than the first voltage, and a lower third voltage is applied to the drain by using the second control line BL, and the third voltage is less than the second voltage. In a possible implementation, for example, the first voltage is 2 V, the second voltage is 1 V, and the third voltage is 0.2 V. In this case, if the transistor of the memory cell stores 1, because holes are accumulated in the channel, the threshold voltage of the transistor is reduced, and the transistor is more likely to be conducted. Therefore, when the transistor of the memory cell stores 1, applying 1 V to the first gate and the second gate is sufficient to conduct the transistor of the memory cell. In this case, a current flowing through the channel is large, and a large current may be read, which is considered as reading 1.

When 0 is written into the transistor of the memory cell, with reference to FIG. 28, a first voltage is applied to the first gate by using the fourth control line structure PL, a third control line structure WL is 0 V, and a negative voltage, for example, -0.7 V, is applied to the drain by using the second control line BL. In this case, holes (positive charges) stored in the channel of the transistor flow out of the drain, and the threshold voltage of the transistor is restored to an initial state. This state is defined as writing 0.

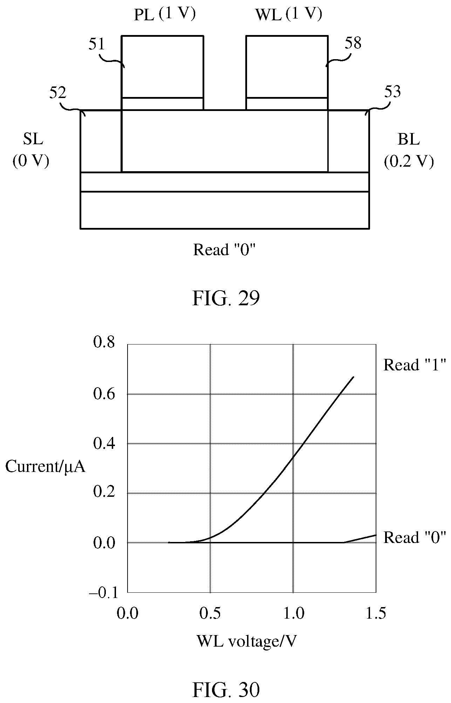

If the transistor of the memory cell stores 0, because the holes are released, charges is not accumulated in the channel, and the threshold voltage of the transistor is restored, that is, compared with the transistor storing 1, the threshold voltage of the transistor storing 0 is higher and is more difficult to be conducted. Therefore, with reference to FIG. 29, when the second voltage is applied to the first gate and the second gate, the transistor of the memory cell is almost not conducted, a current flowing through the channel is almost 0, and a current that can be read is small or a read current is almost 0, which is considered as reading 0.

It can be learned that, in this way, a difference between currents read when 0 is read and 1 is read increases. As shown in FIG. 30, reading windows or distinguishing degrees of 0 and 1 significantly increase.

For example, based on the floating body effect transistor with the dual-gate structure provided in this embodiment of this application, an embodiment of this application provides another memory array. The memory array provided in this embodiment of this application includes a plurality of memory layers formed on a substrate, and the plurality of memory layers are stacked in a first direction perpendicular to the substrate, to increase a storage density of the memory array.

A structure of the memory array provided in this embodiment of this application is basically the same as a structure of the memory array provided in the foregoing embodiment. A difference lies in that a structure of each memory cell in the memory layer is different, and further, a structure of a control line connected to the memory cell is also different. In the foregoing example, a transistor of the memory cell is a single-gate transistor. In the memory array provided in this embodiment of this application, a transistor of the memory cell is a dual-gate transistor, including a first gate and a second gate. The memory array further includes a fourth control line, the first gate is connected to a third control line, and the second gate is connected to the fourth control line. For brevity of description, only a difference is described in this embodiment of this application.

The memory layer includes a plurality of memory cells, the memory cells may be disposed in a form of a memory cell group, and the memory cell groups are arranged in a manner of rows and columns. For example, the memory layer includes m rows and n columns of memory cell groups, and each memory cell group includes two memory cells: a first memory cell and a second memory cell. In addition, the first memory cell and the second memory cell are distributed in a second direction parallel to the substrate. For example, the second direction is an X direction shown in the figure.

In this embodiment of this application, because a transistor of each memory cell includes a first gate and a second gate, the first gate is connected to the third control line, the second gate is connected to the fourth control line, and the first gate and the second gate are paired, the third control line and the fourth control line are also disposed in pairs. A fourth control line structure is basically the same as a third control line structure.

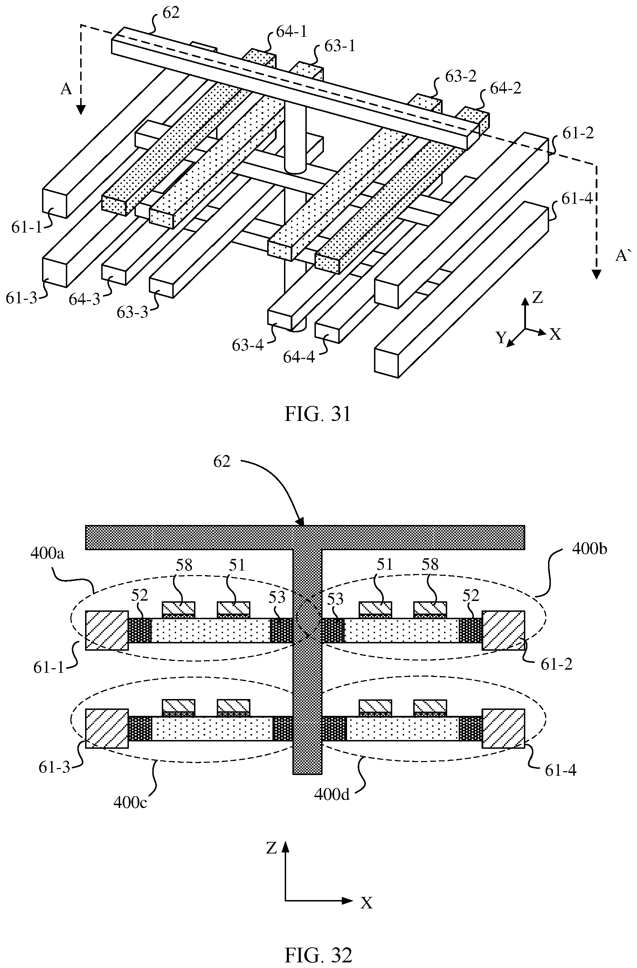

For example, based on FIG. 16, with reference to FIG. 31 and FIG. 32, FIG. 31 is a diagram of a structure of another memory array according to an embodiment of this application, and FIG. 32 is a cutaway view of the memory array shown in FIG. 31 in an A-A' direction.

The memory array shown in FIG. 31 and FIG. 32 shows two memory layers. Each memory layer includes two memory cells, and there are four memory cells in total, which are respectively a first memory cell 400a, a second memory cell 400b, a third memory cell 400c, and a fourth memory cell 400d.

The first memory cell 400a and the third memory cell 400c are distributed in a first direction, and the second memory cell 400b and the fourth memory cell 400d are distributed in the first direction.

The first memory cell 400a and the second memory cell 400b are distributed in a second direction, second terminals 53 of transistors of the two memory cells are connected together, and the two memory cells form a memory cell group.

The third memory cell 400c and the fourth memory cell 400d are distributed in the second direction, second terminals 53 of transistors of the two memory cells are connected together, and the two memory cells form a memory cell group.

A first terminal 52 of the transistor of the first memory cell 400a is connected to a first control line structure 61-1, a first terminal 52 of the second memory cell 400b is connected to a first control line structure 61-2, and the second terminals 53 of the transistors of the first memory cell 400a and the second memory cell 400b are jointly connected to a second control line structure 62. A first gate 51 of the transistor of the first memory cell 400a is connected to a third control line structure 63-1, a second gate 58 is connected to a fourth control line structure 64-1, a first gate 51 of the transistor of the second memory cell 400b is connected to a third control line structure 63-2, and a second gate 58 of the transistor of the second memory cell 400b is connected to a fourth control line structure 64-2. It can be learned that, because a manner of disposing the second gate 58 is basically the same as a manner of disposing the first gate 51, a structure of the fourth control line structure 64 is basically the same as a structure of the third control line structure 63.

In the memory array provided in this embodiment of this application, the transistor of the memory cell includes the first gate and the second gate. In this way, when data is written, charges may be stored in a channel region between the first gate and the second gate, and a distance between a charge storage position and the first terminal or the second terminal of the transistor is increased. Therefore, retention time of data can be increased.

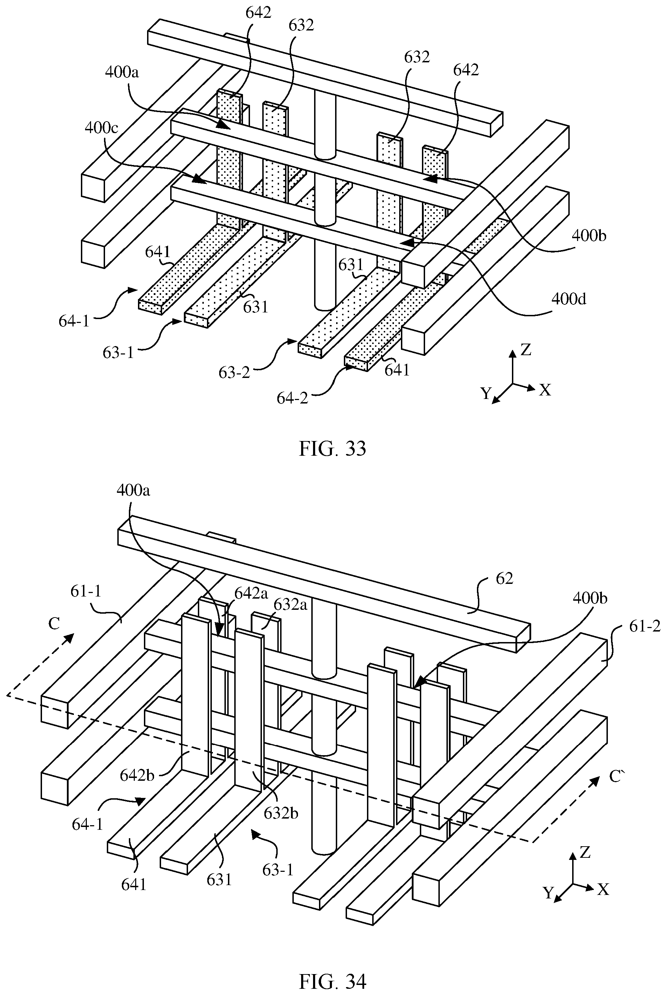

In another embodiment of this application, based on FIG. 18, FIG. 33 is a diagram of another memory array according to an embodiment of this application. In the memory array, a transistor of a memory cell includes a first gate and a second gate, the first gate is connected to a third control line structure, the second gate is connected to a fourth control line structure, the third control line structure includes a horizontal control line and a vertical control line, the horizontal control line of the third control line structure extends in a third direction, and the vertical control line of the third control line structure extends in a first direction. The fourth control line structure also includes a horizontal control line and a vertical control line, the horizontal control line of the fourth control line structure extends in the third direction, and the vertical control line of the fourth control line structure extends in the first direction.

For example, with reference to FIG. 33, the third control line structure is connected to the first gate of the transistor distributed in the first direction. For example, the vertical control line 632 of the third control line structure 63-1 is connected to the first gates of the transistors of the first memory cell 400a and the third memory cell 400c, the vertical control line 632 of the third control line structure 63-2 is connected to the first gates of the transistors of the second memory cell 400b and the fourth memory cell 400d, the fourth control line structure is connected to the second gate of the transistor distributed in the first direction, for example, the vertical control line 642 of the fourth control line structure 64-1 is connected to the second gates of the transistors of the first memory cell 400a and the third memory cell 400c, and the vertical control line 642 of the fourth control line structure 64-2 is connected to the second gates of the transistors of the second memory cell 400b and the fourth memory cell 400d.

In the memory array shown in FIG. 33, the horizontal control line 631 of the third control line structure 63 is connected to an end that is of the vertical control line 632 of the third control line structure 63 and that is close to the substrate, and the horizontal control line 641 of the fourth control line structure 64 is connected to an end that is of the vertical control line 642 of the fourth control line structure 64 and that is close to the substrate. In some other implementations, the horizontal control lines of the third control line structure and the fourth control line structure may be further connected to an end that is of the vertical control line and that is away from the substrate.

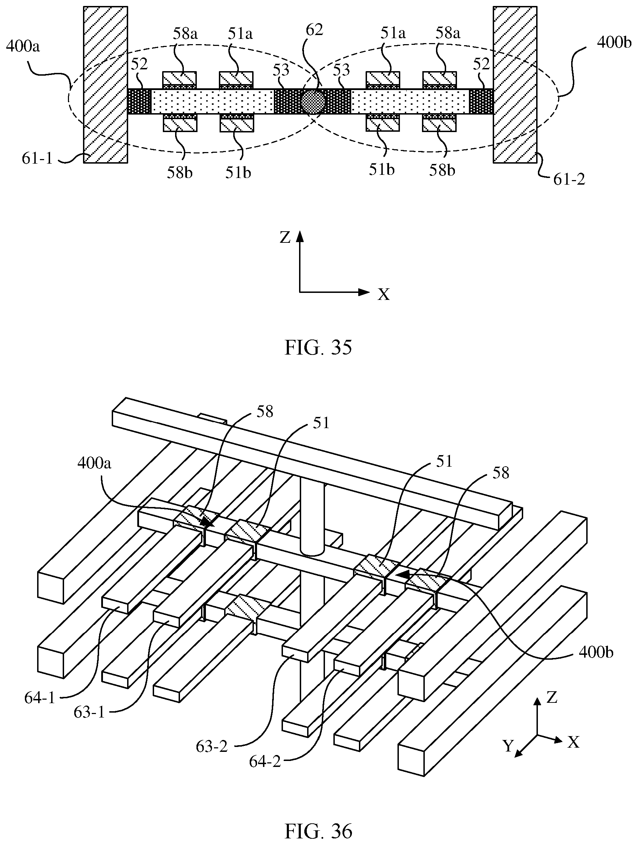

For example, based on FIG. 22 and FIG. 23, with reference to FIG. 34 and FIG. 35, FIG. 34 is a diagram of another memory array according to an embodiment of this application, and FIG. 35 is a cutaway view of the array shown in FIG. 34 in a C-C' direction.

In the memory array, a transistor of a memory cell includes a first gate and a second gate, where the first gate may include two opposite electrodes, and the second gate may also include two opposite electrodes. For example, the first gate 51 of the first memory cell 400a includes the first electrode 51a and the second electrode 51b, the second gate 58 of the first memory cell 400a includes a first electrode 58a and a second electrode 58b, the first gate 51 of the second memory cell 400b includes the first electrode 51a and the second electrode 51b, and the second gate 58 of the second memory cell 400b includes a first electrode 58a and a second electrode 58b.

In this case, the vertical control line 632 of the third control line structure 63 may also include two opposite electrode lines, and the vertical control line 642 of the fourth control line structure 64 may also include two opposite electrode lines. The gate with the dual-electrode structure may increase a contact area between the gate of the transistor of the memory cell and the channel, and enhance a control capability of the gate on the channel.

For example, the third control line structure 63-1 includes the horizontal control line 631 and the vertical control line 632, the vertical control line 632 includes the first electrode line 632a and the second electrode line 632b that are opposite to each other, and the first electrode line 632a and the second electrode line 632b extend in the first direction perpendicular to the substrate. The first electrode line of the third control line structure 63-1 is connected to the first electrode of the first gate of the transistor distributed in the first direction, for example, is connected to the first electrode 51a of the first gate 51 of the transistor of the first memory cell 400a. The second electrode line 632b is connected to the second electrode of the first gate of the transistor distributed in the first direction, for example, is connected to the second electrode 51b of the first gate 51 of the transistor of the first memory cell 400a.

Similarly, the fourth control line structure 64-1 includes a horizontal control line 641 and a vertical control line 642, the vertical control line 642 includes a first electrode line 642a and a second electrode line 642b that are opposite to each other, and the first electrode line 642a and the second electrode line 642b extend in the first direction perpendicular to the substrate. The first electrode line 642a of the fourth control line structure 64-1 is connected to the first electrode of the second gate of the transistor distributed in the first direction, for example, is connected to the first electrode 58a of the second gate 58 of the transistor of the first memory cell 400a. The second electrode line 642b is connected to the second electrode of the second gate of the transistor distributed in the first direction, for example, is connected to the second electrode 58b of the second gate 58 of the transistor of the first memory cell 400a.

For example, based on FIG. 24, FIG. 36 is a diagram of another memory array according to an embodiment of this application. In the memory array, a first gate 51 of a transistor of a memory cell has a ring electrode structure, a second gate 58 may also have a ring electrode structure, a third control line structure 63 and a fourth control line structure 64 may extend in a third direction, the third control line structure is connected to the first gate 51 of the transistor distributed in the third direction, and the fourth control line structure is connected to the second gate 58 of the transistor distributed in the third direction. For example, the third control line structure 63-1 is connected to the first gate 51 of the memory cell 400a, the fourth control line structure 64-1 is connected to the second gate 58 of the memory cell 400a, the third control line structure 63-2 is connected to the first gate 51 of the transistor of the memory cell 400b, and the fourth control line structure 64-2 is connected to the second gate 58 of the transistor of the memory cell 400b.

According to the memory array provided in this embodiment of this application, the plurality of memory layers are stacked in the direction perpendicular to the substrate to increase the storage density. The transistor of each memory cell includes the first gate and the second gate that do not contact each other. The first gate and the second gate are distributed in the extension direction of the channel, and separately cover a part of the channel. In this way, when data is retained, for example, when a state 1 is retained, positive charges may be accumulated in the channel region between the first gate and the second gate, instead of the region near the first terminal or the second terminal. Therefore, a positive charge accumulation position is farther away from the first terminal or the second terminal, and it is not easy to flow out through the first terminal or the second terminal, to increase retention time of data.

For example, for the memory array provided in this embodiment of this application, the memory cell is formed by a single transistor, and a material for the first terminal, the second terminal, and the channel of the transistor may be a semiconductor material such as silicon (Si), polycrystalline silicon (poly-Si), or silicon-germanium (SiGe), or any combination thereof.

The gate oxide dielectric layer is disposed between the gate and the channel to separate the gate from the channel. The gate oxide dielectric layer may be made of an insulation material. For example, a material for the gate oxide dielectric layer may be an insulation material such as silicon dioxide (SiO₂), aluminum oxide (Al₂O₃), hafnium dioxide (HfO₂), zirconium dioxide (ZrO₂), titanium dioxide (TiO₂), yttrium oxide (Y₂O₃), and silicon nitride (Si₃N₄), or any combination thereof.

A material for a control line structure such as the first control line structure, the second control line structure, the third control line structure, and the fourth control line structure may be a conductive material, for example, a material such as titanium nitride (TiN), titanium (Ti), gold (Au), tungsten (W), molybdenum (Mo), indium tin oxide (In-Ti-O), aluminum (Al), copper (Cu), ruthenium (Ru), and silver (Ag), or any combination thereof. A material for the third control line structure and the fourth control line structure may be the same as a material for the first gate and the second gate.

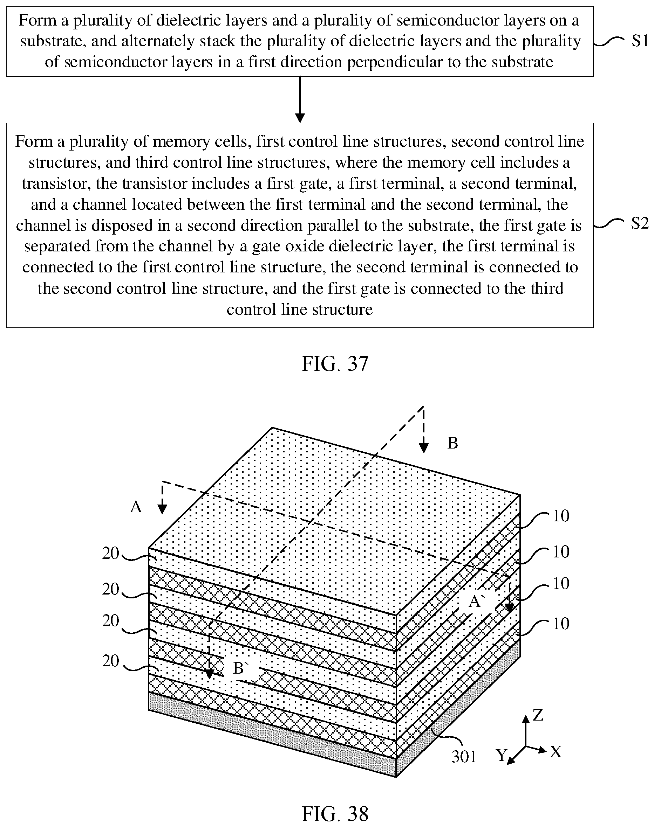

In addition, an embodiment of this application further provides a memory array manufacturing method. Refer to FIG. 37. The method includes the following steps.

S1: Form a plurality of dielectric layers and a plurality of semiconductor layers on a substrate, and alternately stack the plurality of dielectric layers and the plurality of semiconductor layers in a first direction perpendicular to the substrate.

For example, if a memory array including 100 memory layers needs to be manufactured, 100 dielectric layers and 100 semiconductor layers are stacked, and two adjacent semiconductor layers may be separated by one dielectric layer.

A material for the semiconductor layer and a material for the dielectric layer are two materials with different selection etching ratios. In this way, the semiconductor layer may not be affected when the dielectric layer is etched.

For example, the semiconductor layer herein may be one or more of semiconductor materials such as Si (silicon), poly-Si (p-Si, polycrystalline silicon), silicon-germanium (SiGe), amorphous-Si (a-Si, amorphous silicon), In-Ga-Zn-O (IGZO, indium gallium zinc oxide) multicomponent compound, ZnO (zinc oxide), ITO (indium tin oxide), TiO₂ (titanium dioxide), MoS₂ (molybdenum disulfide), and WS₂ (tungsten disulfide).

An insulation material such as silicon-germanium (SiGe) may be selected for the dielectric layer.

S2: Form a plurality of memory cells, first control line structures, second control line structures, and third control line structures, where the memory cell includes a transistor, the transistor includes a first gate, a first terminal, a second terminal, and a channel located between the first terminal and the second terminal, the channel is disposed in a second direction parallel to the substrate, the first gate is separated from the channel by a gate oxide dielectric layer, the first terminal is connected to the first control line structure, the second terminal is connected to the second control line structure, and the first gate is connected to the third control line structure.

The following describes a specific process flow in step S1 and step S2 with reference to the accompanying drawings.

As shown in FIG. 38, a plurality of first dielectric layers 10 and a plurality of semiconductor layers 20 are formed on a substrate 301, and the plurality of semiconductor layers 20 and the plurality of first dielectric layers 10 are alternately stacked in a direction perpendicular to the substrate. The foregoing example describes materials that can be selected for the semiconductor layer and the dielectric layer, and details are not described herein again.

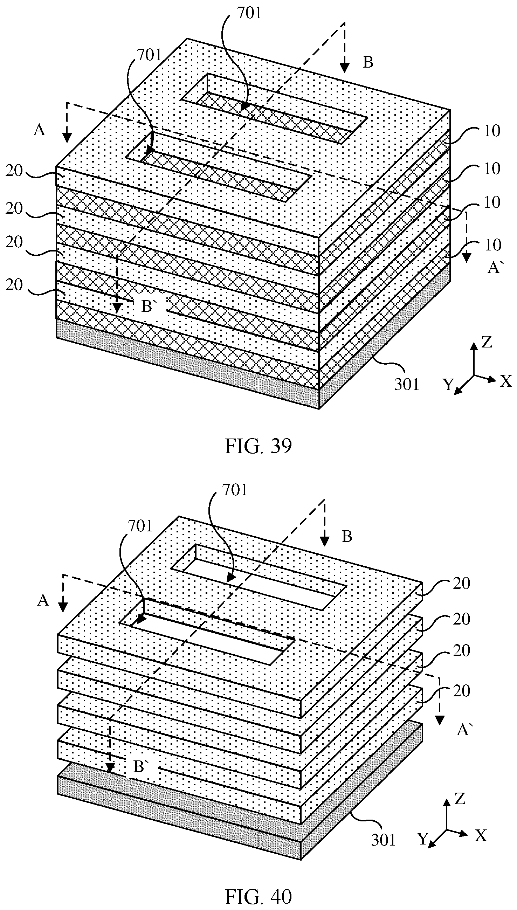

As shown in FIG. 39, a plurality of first trenches 701 are provided in a third direction. The plurality of first trenches 701 may be spaced in a third direction, and each first trench 701 passes through the plurality of semiconductor layers 20 and the plurality of first dielectric layers 10 until reaching the substrate 301. A semiconductor layer between two adjacent first trenches 701 may be used to form a channel of a transistor, and the first trenches 701 separate channels of different transistors in the third direction.

As shown in FIG. 40, the first dielectric layers 10 are removed. For example, the first dielectric layers 10 may be removed by etching of the first trenches 701, and a degree of removal of the first dielectric layers 10 may be controlled by adjusting etching time. For example, the first dielectric layers 10 may be all removed or partially removed. Because a material for the semiconductor layer 20 and a material for the first dielectric layer 10 are two materials with different selection etching ratios, the semiconductor layer is not affected during etching of the dielectric layer.

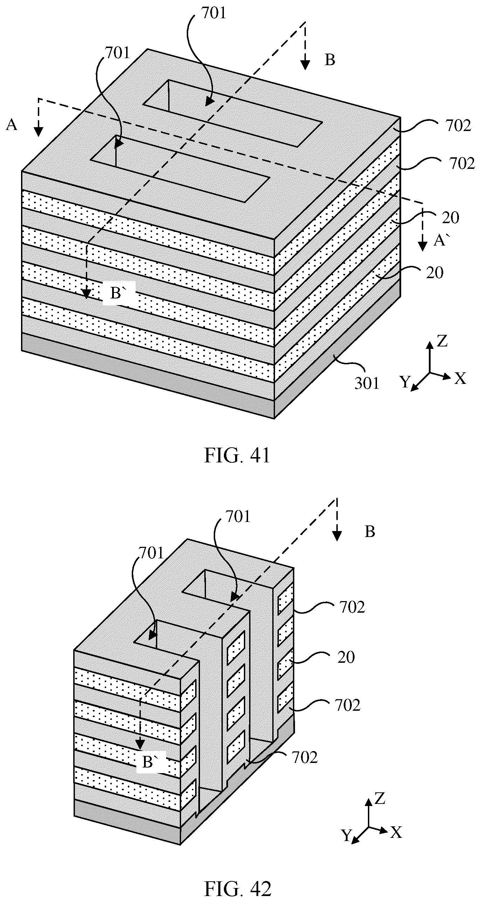

As shown in FIG. 41 and FIG. 42, a material for a gate oxide dielectric layer grows to fill a region in which the original first dielectric layers 10 are located, to form a plurality of second dielectric layers 702. For example, the material for the gate oxide dielectric layer may include one or more of insulation materials such as SiO₂ (silicon dioxide), Al₂O₃ (aluminum oxide), HfO₂ (hafnium dioxide), ZrO₂ (zirconium dioxide), TiO₂ (titanium dioxide), Y₂O₃ (yttrium oxide), and Si₃N₄ (silicon nitride). The second dielectric layers 702 fill the region of the original first dielectric layers 10, separate, in a direction parallel to the substrate, channels of transistors at a same memory layer, and separate, in a direction perpendicular to the substrate, channels of transistors at different memory layers. FIG. 42 is a cross-sectional view in a B-B' direction after a material for a gate oxide dielectric layer is filled.

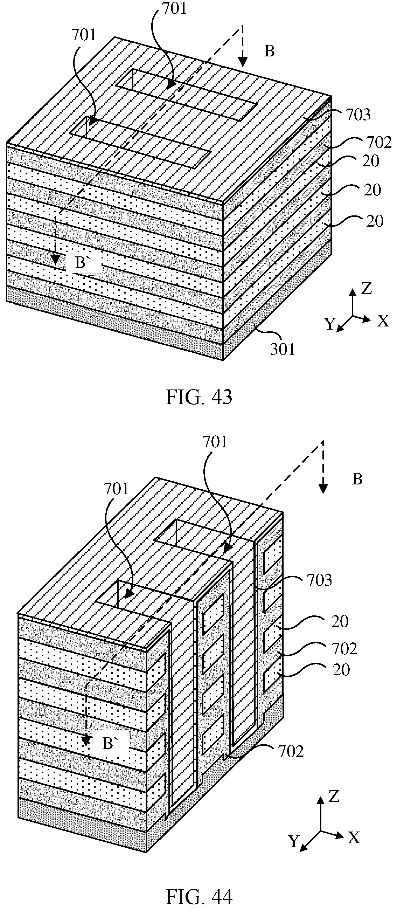

As shown in FIG. 43 and FIG. 44, a gate material is deposited in the first trench 701 to form a conductive layer 703. In this embodiment of this application, the first gate of the transistor and the third control line structure may be made of a same material, and are integrated. Therefore, herein, it may also be considered that the material for the third control line structure is deposited. FIG. 44 is a cross-sectional view in a B-B' direction after a gate material is filled.

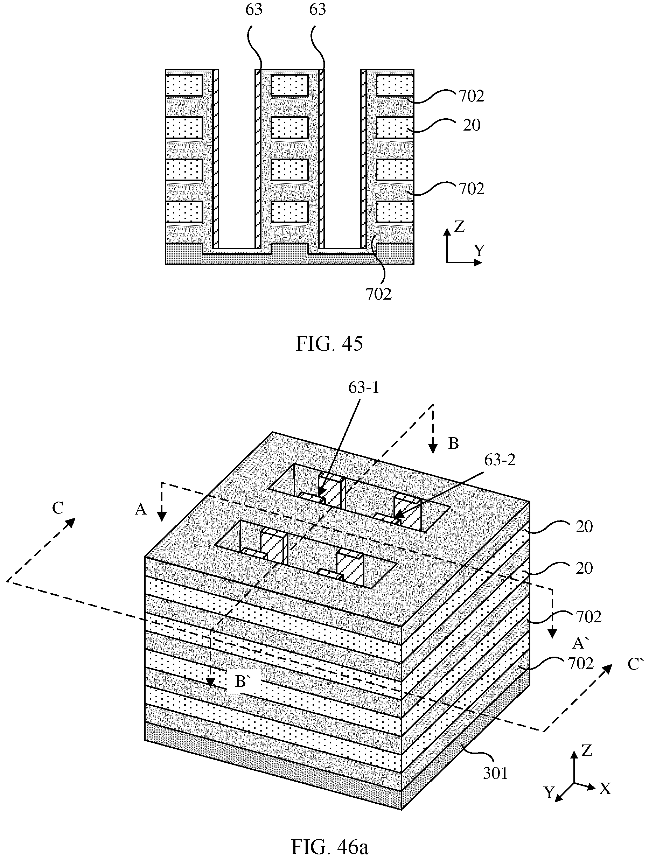

As shown in FIG. 45 and FIG. 46a, a part of the conductive layer 703 is removed to form the first gate 51 of the transistor and the third control line structure 63. Herein, with reference to FIG. 22 in the foregoing example, the third control line structure 63 extends in the first direction perpendicular to the substrate, and a quantity of third control line structures 63 is the same as a quantity of first gates 51.

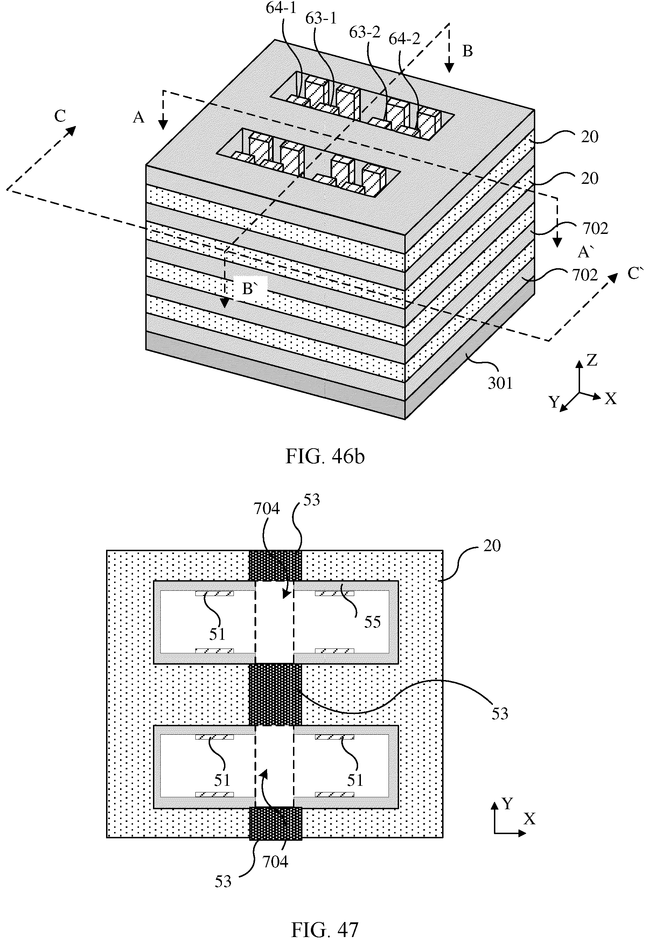

Alternatively, in another implementation of this application, as shown in FIG. 45 and FIG. 46b, with reference to FIG. 34 in the foregoing example, referring to FIG. 46b, a part of the conductive layer 703 may be alternatively removed to form the first gate 51 and the second gate 58 of the transistor, and form the third control line structure 63 and the fourth control line structure 64.

Still based on FIG. 46a, FIG. 47 is a cutaway view in a C-C' direction. A first hole 704 is provided in the first trench 701, and the first hole 704 is located in a middle position of the first trench 701. A part of the second dielectric layer 702 is removed in the direction perpendicular to the substrate, so that a material for the semiconductor layer 20 between two adjacent first trenches 701 is exposed through the first hole 704. Then, the material for the exposed semiconductor layer 20 between the two adjacent first trenches 701 is doped through the first hole 704, to form the second terminal 53 of the transistor of the first memory cell and the second terminal 53 of the transistor of the second memory cell. Herein, the second terminal 53 of the transistor of the first memory cell is connected to the second terminal 53 of the transistor of the second memory cell, and shares a same electrode. Alternatively, it may be considered that the second terminal 53 of the transistor of the first memory cell and the second terminal 53 of the transistor of the second memory cell are integrated.

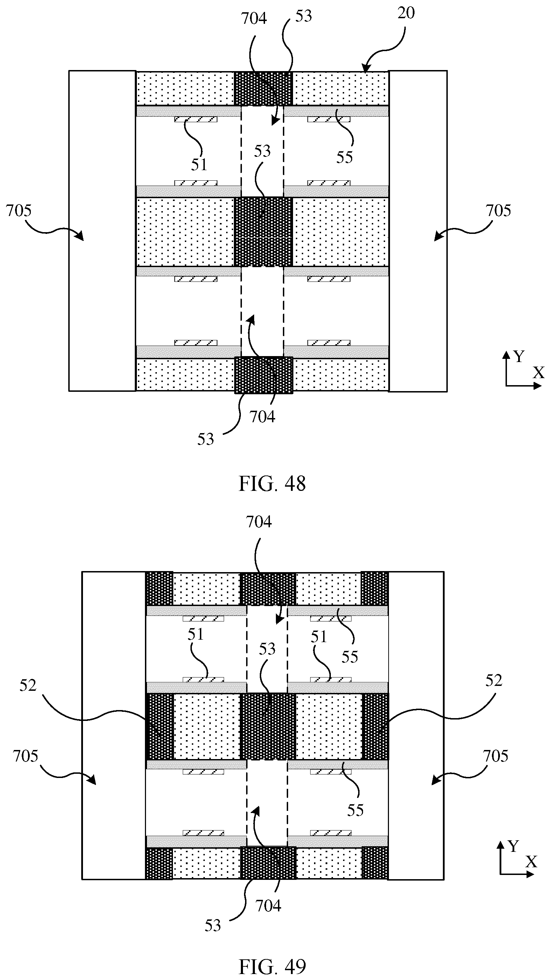

FIG. 48 is a cutaway view in a C-C' direction. A plurality of second trenches 705 are provided. In this embodiment of this application, distribution in the second direction is referred to as one row, distribution in the third direction is referred to as one column, and the second trenches 705 are located between two adjacent columns of first trenches 701, and separate channels of a plurality of transistors distributed in the third direction. Each second trench 705 passes through the plurality of semiconductor layers 20 and second dielectric layers 702 until reaching the substrate.

FIG. 49 is a cutaway view in a C-C' direction. A material for the semiconductor layer 20 is doped through the second trench 705, to form the first terminal 52 of the transistor. For example, with reference to FIG. 49, the first terminal 52 of the transistor of the first memory cell and the first terminal 52 of the transistor of the second memory cell may be formed after doping.

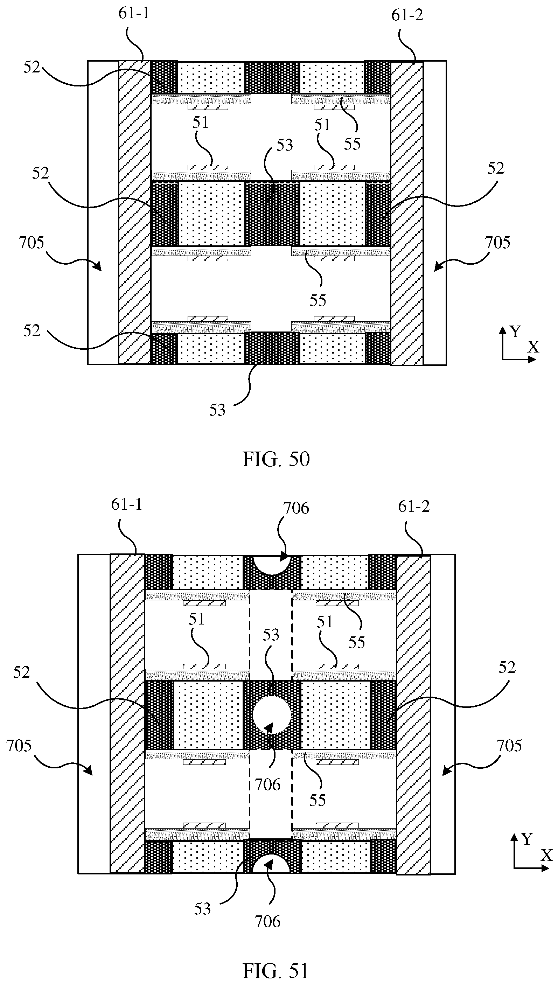

FIG. 50 is a cutaway view in a C-C' direction. A first control line structure 61 is formed outside the first terminal 52. For example, with reference to FIG. 50, a first control line structure 61-1 and a first control line structure 61-2 are formed. The first control line structure 61-1 extends in the third direction, and the first control line structure is connected to first terminals 52 of a plurality of transistors distributed in the third direction.

FIG. 51 is a cutaway view in a C-C' direction. A plurality of second holes 706 are provided, and the second holes 706 pass through, in the direction perpendicular to the substrate, second terminals 53 of a plurality of transistors distributed in the direction perpendicular to the substrate.

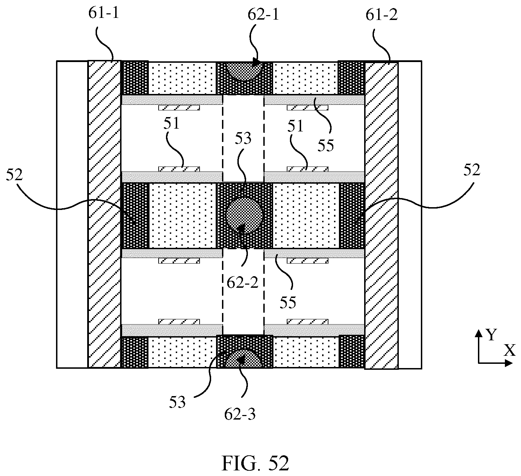

FIG. 52 is a cutaway view in a C-C' direction. Then, a material for a second control line structure is filled in the second hole 706, to form the second control line structure. For example, second control line structures 62-1, 62-2, and 62-3 are formed.

In the foregoing example, both the formed third control line structure and the formed second control line structure extend in the direction perpendicular to the substrate, and may further form the third control line structure and the second control line structure that extend in the direction parallel to the substrate.

For example, the horizontal control line of the third control line structure may be formed on the substrate in advance, and the horizontal control line of the third control line structure extends in the third direction, and then the plurality of first dielectric layers 10 and semiconductor layers 20 are formed on the horizontal control line of the third control line structure. Finally, when the vertical control line of the third control line structure is formed, the vertical control line of the third control line structure is connected to the horizontal control line.

Alternatively, after the vertical control line of the third control line structure is formed, the horizontal control line of the third control line structure may be formed on a side that is of the vertical control line and that is away from the substrate. The horizontal control line of the third control line structure extends in the third direction, and is connected to a plurality of vertical control lines distributed in the third direction, to form one integrated third control line structure.

Similarly, after the vertical control line of the second control line structure is formed, a horizontal control line extending in the second direction may be further formed, to connect one row of horizontal control lines of the second control line structure, and form one integrated second control line structure.

In the foregoing example, the semiconductor layer is doped to form the first terminal and the second terminal of the transistor. In some other process flows, a trench may alternatively be provided on each semiconductor layer, and a metal material is filled in the trench to form the first terminal and the second terminal of the transistor.

It can be learned from the process flows shown in FIG. 38 to FIG. 52 that according to the method provided in this embodiment of this application, the plurality of semiconductor layers and dielectric layers are alternately stacked first, and then the first trench is provided. The dielectric layers between the semiconductor layers are removed, the gate oxide dielectric layer is filled in a position of the original dielectric layers, and then the third control line structure and the first gate of the transistor are formed. The hole or the trench is provided, the semiconductor layer is doped to form the first terminal and the second terminal of the transistor, and then the first control line structure and the second control line structure are formed, to manufacture a multi-layer stacked memory array, instead of manufacturing one layer of memory array and then manufacturing another layer of memory array. Therefore, the process flow can be simplified, process difficulty can be reduced, a product quality rate can be increased, and the storage density of the memory can be increased. In addition, manufacturing costs of the memory can also be reduced.

In the descriptions of this specification, the described specific features, structures, materials, or characteristics may be combined in a proper manner in any one or more of embodiments or examples.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A memory array, wherein the memory array comprises:
a substrate; and
a plurality of memory layers formed on the substrate, wherein the plurality of memory layers are stacked in a first direction perpendicular to the substrate;
the memory layer comprises a plurality of memory cells and first control line structures, the memory cell comprises a floating body effect transistor, and the floating body effect transistor comprises a first gate, a first terminal, a second terminal, and a channel located between the first terminal and the second terminal;
the channel is disposed in a second direction parallel to the substrate, and the first gate is separated from the channel by a gate oxide dielectric layer; and
the memory array further comprises a plurality of second control line structures and third control line structures, the first terminal of the floating body effect transistor is connected to the first control line structure, the second terminal is connected to the second control line structure, and the first gate is connected to the third control line structure.

2. The memory array according to claim 1, wherein the floating body effect transistor further comprises a second gate, the second gate is separated from the channel by a gate oxide dielectric layer, the second gate and the first gate are distributed in the second direction, the second gate is close to the first terminal, and the first gate is close to the second terminal; and
the memory array further comprises a plurality of fourth control line structures, and the second gate is connected to the fourth control line structure.

3. The memory array according to claim 1 or 2, wherein the second control line structure comprises a vertical control line extending in the first direction, and the vertical control line of the second control line structure is connected to the second terminal of the floating body effect transistor distributed in the first direction.

4. The memory array according to claim 3, wherein the second control line structure further comprises a horizontal control line extending in the second direction, and the horizontal control line of the second control line structure is connected to the vertical control line of the second control line structure distributed in the second direction.

5. The memory array according to any one of claims 1 to 4, wherein the plurality of memory cells comprise a first memory cell and a second memory cell, and the first memory cell and the second memory cell are distributed in the second direction;
a second terminal of a floating body effect transistor of the first memory cell is close to a second terminal of a floating body effect transistor of the second memory cell; and
the second terminal of the floating body effect transistor of the first memory cell and the second terminal of the floating body effect transistor of the second memory cell are connected to a same second control line structure.

6. The memory array according to any one of claims 2 to 5, wherein the third control line structure extends in a third direction parallel to the substrate, the third direction is perpendicular to the second direction, and the third control line structure is connected to the first gate of the floating body effect transistor distributed in the third direction; and
the fourth control line structure extends in the third direction, and the fourth control line structure is connected to the second gate of the floating body effect transistor distributed in the third direction.

7. The memory array according to any one of claims 2 to 5, wherein the third control line structure comprises a vertical control line extending in the first direction, and the vertical control line of the third control line structure is connected to the first gate of the floating body effect transistor distributed in the first direction; and
the fourth control line structure comprises a vertical control line extending in the first direction, and the vertical control line of the fourth control line structure is connected to the second gate of the floating body effect transistor distributed in the first direction.

8. The memory array according to claim 7, wherein the third control line structure comprises a horizontal control line extending in a third direction parallel to the substrate, the third direction is perpendicular to the second direction, and the horizontal control line of the third control line structure is connected to the vertical control line of the third control line structure distributed in the third direction; and
the fourth control line structure comprises a horizontal control line extending in the third direction, and the horizontal control line of the fourth control line structure is connected to the vertical control line of the fourth control line structure distributed in the third direction.

9. The memory array according to claim 7, wherein the third control line structure comprises a horizontal control line extending in the second direction, and the horizontal control line of the third control line structure is connected to the vertical control line of the third control line structure distributed in the second direction; and
the fourth control line structure comprises a horizontal control line extending in the second direction, and the horizontal control line of the fourth control line structure is connected to the vertical control line of the fourth control line structure distributed in the second direction.

10. The memory array according to any one of claims 2 to 9, wherein the first gate and the second gate are ring-shaped, the first gate surrounds the channel, and the second gate surrounds the channel.

11. The memory array according to any one of claims 7 to 9, wherein the first gate comprises a first electrode and a second electrode that are paired, the first electrode and the second electrode are distributed in the third direction parallel to the substrate, the third direction is perpendicular to the second direction, and the channel is located between the first electrode and the second electrode; and
the second gate comprises a first electrode and a second electrode that are paired, the first electrode and the second electrode of the second gate are distributed in the third direction, and the channel is located between the first electrode and the second electrode of the second gate.

12. The memory array according to claim 11, wherein the vertical control line of the third control line structure comprises a first electrode line structure and a second electrode line structure that are opposite to each other, the first electrode line structure is connected to the first electrode of the first gate of the floating body effect transistor distributed in the first direction, and the second electrode line structure is connected to the second electrode of the first gate of the floating body effect transistor distributed in the first direction; and
the vertical control line of the fourth control line structure comprises a first electrode line structure and a second electrode line structure that are opposite to each other, the first electrode line structure of the fourth control line is connected to the first electrode of the second gate of the floating body effect transistor distributed in the first direction, and the second electrode line structure of the fourth control line structure is connected to the second electrode of the second gate of the floating body effect transistor distributed in the first direction.

13. The memory array according to any one of claims 1 to 12, wherein the first control line structure extends in the third direction parallel to the substrate, and the first control line structure is connected to the first terminal of the floating body effect transistor distributed in the third direction.

14. The memory array according to claim 2, wherein the first control line structure is a source line, the second control line structure is a bit line, the third control line structure is a word line, and the fourth control line structure is a plate line.

15. A memory, comprising:
the memory array according to any one of claims 1 to 14; and
a controller, wherein the controller is electrically connected to the memory array, and the controller is configured to control reading and writing of the memory array.

16. A memory array manufacturing method, wherein the method comprises:
forming a plurality of dielectric layers and a plurality of semiconductor layers on a substrate, and alternately stacking the plurality of dielectric layers and the plurality of semiconductor layers in a first direction perpendicular to the substrate; and
forming a plurality of memory cells, first control line structures, second control line structures, and third control line structures, wherein the memory cell comprises a floating body effect transistor, the floating body effect transistor comprises a first gate, a first terminal, a second terminal, and a channel located between the first terminal and the second terminal, the channel is disposed in a second direction parallel to the substrate, the first gate is separated from the channel by a gate oxide dielectric layer, the first terminal is connected to the first control line structure, the second terminal is connected to the second control line structure, and the first gate is connected to the third control line structure.

17. The method according to claim 16, wherein forming the plurality of memory cells, first control line structures, second control line structures, and third control line structures comprises:
forming the first gate of the floating body effect transistor, wherein the first gate comprises a first electrode and a second electrode that are paired, the first electrode and the second electrode are distributed in a third direction parallel to the substrate, the third direction is perpendicular to the second direction, and the channel is located between the first electrode and the second electrode; and
forming a vertical control line of the third control line structure, wherein the vertical control line of the third control line structure comprises a first electrode line and a second electrode line that are paired, the first electrode line is connected to the first electrode of the first gate of the floating body effect transistor distributed in the first direction, and the second electrode line is connected to the second electrode of the first gate of the floating body effect transistor distributed in the first direction.

18. The method according to claim 17, wherein forming the plurality of memory cells, first control line structures, second control line structures, and third control line structures further comprises:
forming a second gate of the floating body effect transistor, wherein the second gate and the first gate are distributed in the second direction, the second gate is close to the first terminal, the first gate is close to the second terminal, the second gate comprises a first electrode and a second electrode that are paired, the first electrode and the second electrode are distributed in the third direction parallel to the substrate, the third direction is perpendicular to the second direction, and the channel is located between the first electrode and the second electrode; and
forming a vertical control line of a fourth control line structure, wherein the vertical control line of the fourth control line structure comprises a first electrode line and a second electrode line that are paired, the first electrode line is connected to the first electrode of the first gate of the floating body effect transistor distributed in the first direction, and the second electrode line is connected to the second electrode of the first gate of the floating body effect transistor distributed in the first direction.

19. The method according to claim 16, wherein forming the plurality of memory cells, first control line structures, second control line structures, and third control line structures comprises:
forming a second terminal of a floating body effect transistor of a first memory cell and a second terminal of a floating body effect transistor of a second memory cell, wherein the second terminal of the floating body effect transistor of the first memory cell is close to the second memory cell, the second terminal of the floating body effect transistor of the second memory cell is close to the first memory cell, and the second terminal of the floating body effect transistor of the first memory cell and the second terminal of the floating body effect transistor of the second memory cell are connected to a same second control line structure.

20. The method according to claim 16, wherein forming the plurality of memory cells, first control line structures, second control line structures, and third control line structures comprises:
forming a vertical control line of the second control line structure, wherein the vertical control line of the second control line structure extends in the first direction, and the vertical control line of the second control line structure is connected to the second terminal of the floating body effect transistor distributed in the first direction.

21. An electronic device, comprising a processor and the memory according to claim 15, wherein the processor is electrically connected to the memory.
